# EUROPEAN PATENT APPLICATION

(11) **EP 4 468 027 A1**
(43) Date of publication of application: **27.11.2024**
(21) Application number: 23743294.3
(22) Date of filing: 18.01.2023
(51) Int. Cl.: G01S 7/481, G01C 3/06, G01S 17/931, H01L 31/12

(54) **MEASUREMENT DEVICE AND MANUFACTURING METHOD FOR MEASUREMENT DEVICE**

(30) Priority: 18.01.2022 JP 2022005809; 18.01.2022 JP 2022005810; 18.01.2022 JP 2022005811
(71) Applicant: KOITO MANUFACTURING CO., LTD., Minato-ku, Tokyo, 108-8711 (JP)
(72) Inventor: DEGUCHI Hirohisa, Shizuoka-shi, Shizuoka 424-8764 (JP); IZUKAWA Koji, Shizuoka-shi, Shizuoka 424-8764 (JP); KOISHIKAWA Naoki, Shizuoka-shi, Shizuoka 424-8764 (JP); SHITARA Mitsuki, Shizuoka-shi, Shizuoka 424-8764 (JP); YAMAZAKI Atsushi, Shizuoka-shi, Shizuoka 424-8764 (JP); DAICHO Yoshinao, Shizuoka-shi, Shizuoka 424-8764 (JP); SAKURAI Kazutoshi, Shizuoka-shi, Shizuoka 424-8764 (JP)
(74) Representative: Hoffmann Eitle
(86) International application number: PCT/JP2023/001408
(87) International publication number: WO 2023/140301

(57) **Abstract**

A measurement device (1) according to the present disclosure comprises: a sensor unit (10) having a light-emitting element (11) that emits light and a light-receiving element (12) that receives reflected light; an optical unit (20) that irradiates an object with the light emitted from the light-emitting element (11), and allows the light-receiving element (12) to receive the reflected light; a holder (40) for holding the sensor unit (10) and the optical unit (20) so as to be movable relative to each other; a substrate (50) fixed to the holder (40); and a deformable support member (80) that supports an end portion of the substrate (50) from the holder (40).

## Description

### TECHNICAL FIELD

The present disclosure relates to a measuring device and a method for manufacturing a measuring device.

### BACKGROUND ART

Patent Literature 1 describes a scanning device that scans laser light by moving a light emitting element and a light receiving element relative to an optical system.

### CITATION LIST

### PATENT LITERATURE

Patent Literature 1: JP2021-500554A

### SUMMARY OF INVENTION

### TECHNICAL PROBLEM

When an optical unit and a sensor unit including a light emitting element and a light receiving element are held by a holder in a relatively movable manner, a substrate may vibrate in a case where the substrate is fixed to the holder.

A first object of the present disclosure is to reduce vibration of the substrate fixed to the holder that holds the sensor unit and the optical unit which move relative to each other.

When the optical unit and the sensor unit including the light emitting element and the light receiving element are held by the holder in a relatively movable manner, the holder may vibrate.

A second object of the present disclosure is to reduce vibration of the holder that holds the sensor unit and the optical unit which move relative to each other.

When a measuring device is attached to a vehicle body, a vehicle body attachment member that holds a body portion of the measuring device is attached to the vehicle body. When both sides in a width direction of the body portion of the measuring device are held by the vehicle body attachment member, the size of the measuring device may be increased in a case where the vehicle body attachment member is integrally formed so as to straddle the body portion in the width direction.

A third object of the present disclosure is to reduce the size of the measuring device while reducing the size of the vehicle body attachment member.

### SOLUTION TO PROBLEM

An aspect of the present disclosure for implementing the first object is a measuring device including: a sensor unit including a light emitting element configured to emit light and a light receiving element configured to receive reflected light; an optical unit configured to irradiate an object with the light emitted from the light emitting element and configured to cause the light receiving element to receive the reflected light; a holder configured to hold the sensor unit and the optical unit in a relatively movable manner; a substrate fixed to the holder; and a support member that is deformable and configured to support an end portion of the substrate from the holder.

An aspect of the present disclosure for implementing the second object is a measuring device including: a sensor unit including a light emitting element configured to emit light and a light receiving element configured to receive reflected light; an optical unit configured to irradiate an object with the light emitted from the light emitting element and configured to cause the light receiving element to receive the reflected light; a spring member including a stationary portion and a vibration portion, and the spring member being configured to hold the sensor unit in a movable manner with respect to the optical unit by attaching the stationary portion to the optical unit and attaching the sensor unit to the vibration portion; and a holder attached to the stationary portion of the spring member and configured to hold the sensor unit and the optical unit in a relatively movable manner.

An aspect of the present disclosure for implementing the third object is a measuring device including: a body portion configured to irradiate an object with light and configured to receive reflected light; and a pair of vehicle body attachment members configured to attach the body portion to a vehicle body while independently holding both sides in a width direction of the body portion.

Another aspect of the present disclosure for implementing the third object is a method for manufacturing a measuring device, the method including: a step of preparing a body portion configured to irradiate an object with light and receive reflected light, and a pair of vehicle body attachment members configured to attach the body portion to a vehicle body; a step of adjusting a positional relation between the pair of vehicle body attachment members; and a step of holding both sides in a width direction of the body portion by the pair of vehicle body attachment members, respectively, in a state where the positional relation between the pair of vehicle body attachment members is adjusted.

Further, the problems disclosed in the present application and the solution thereto will become apparent from the section of the embodiments for carrying out the invention and the drawings.

### ADVANTAGEOUS EFFECTS OF INVENTION

According to the present disclosure, it is possible to reduce vibration of a substrate fixed to a holder that holds a sensor unit and an optical unit which move relative to each other.

In addition, according to the present disclosure, it is possible to reduce vibration of a holder that holds a sensor unit and an optical unit which move relative to each other.

Furthermore, according to the present disclosure, it is possible to reduce a size of a measuring device while reducing a size of a vehicle body attachment member.

### BRIEF DESCRIPTION OF DRAWINGS

[FIG. 1A] FIG. 1A is a perspective view of a measuring device 1.
[FIG. 1B] FIG. 1B is a perspective view of the measuring device 1 in a state where a vehicle body attachment member 100 is removed from a body portion 3.
[FIG. 2] FIG. 2 is a schematic view of the body portion 3.
[FIG. 3A] FIG. 3A illustrates two-dimensional scanning of laser light.
[FIG. 3B] FIG. 3B illustrates two-dimensional scanning on a certain frame.
[FIG. 3C] FIG. 3C illustrates two-dimensional scanning by a plurality of channels.
[FIG. 4] FIG. 4 illustrates a state where a housing 30 is removed.
[FIG. 5] FIG. 5 illustrates a state where a holder 40 and a processing substrate 50 are removed.
[FIG. 6] FIG. 6 illustrates a spring member 60.
[FIG. 7] FIG. 7 illustrates the processing substrate 50 fixed on the holder 40.
[FIG. 8] FIG. 8 illustrates a state where the processing substrate 50 (and shield member 91) is removed from the holder 40.
[FIG. 9] FIG. 9 illustrates a state where a support member 80 supports the processing substrate 50.
[FIG. 10] FIG. 10 is a perspective view of the support member 80.
[FIG. 11A] FIG. 11A illustrates an inner wall surface of an upper housing 32.
[FIG. 11B] FIG. 11B is a cross sectional view illustrating a relation between a projection amount of a convex portion 32B of the upper housing 32 and a height of a chip 55.
[FIG. 12] FIG. 12 is a perspective view of the body portion 3 as viewed from another angle.
[FIG. 13] FIG. 13 is an exploded view illustrating an optical unit 20, the spring member 60, and the holder 40.
[FIG. 14A] FIG. 14A illustrates a state before the holder 40 is attached.
[FIG. 14B] FIG. 14B illustrates a state after the holder 40 is attached.
[FIG. 15] FIG. 15 is a cross sectional view of the measuring device 1.
[FIG. 16A] FIG. 16A illustrates the vehicle body attachment member 100.
[FIG. 16B] FIG. 16B is a perspective view of a first attachment member 110.
[FIG. 17] FIG. 17 illustrates an insert component 24 of a lens housing 23.
[FIG. 18] FIG. 18 illustrates an end portion of a vibration portion 62 of the spring member 60.
[FIG. 19A] FIG. 19A illustrates a state where an attachment screw 97 is attached.
[FIG. 19B] FIG. 19B illustrates a state where the attachment screw 97 is attached.
[FIG. 20] FIG. 20 illustrates a jig 200.
[FIG. 21] FIG. 21 illustrates a state where the vehicle body attachment member 100 is set in the jig 200.
[FIG. 22] FIG. 22 illustrates a positional relation among members set in the jig 200.
[FIG. 23] FIG. 23 illustrates a state where a contact portion 203 and a projection portion 41 are in contact with each other.
[FIG. 24A] FIG. 24A illustrates a vehicle body attachment member 100' according to a comparative example.
[FIG. 24B] FIG. 24B illustrates the vehicle body attachment member 100' according to the comparative example.

### DESCRIPTION OF EMBODIMENTS

Hereinafter, embodiments of the present disclosure will be described with reference to the drawings. In the following description, the same or similar configurations are denoted by the same reference numerals, and redundant description thereof may be omitted.

### <Overall Configuration>

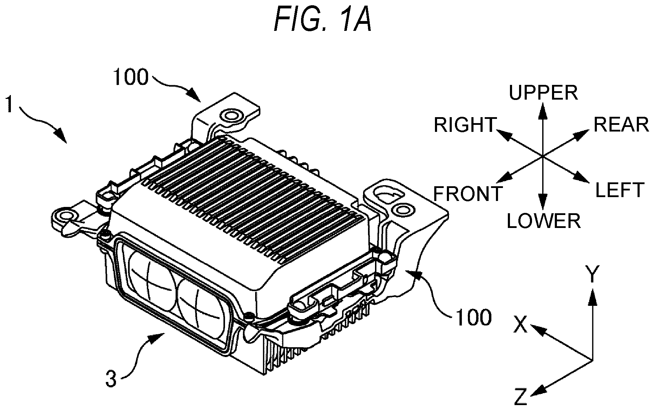

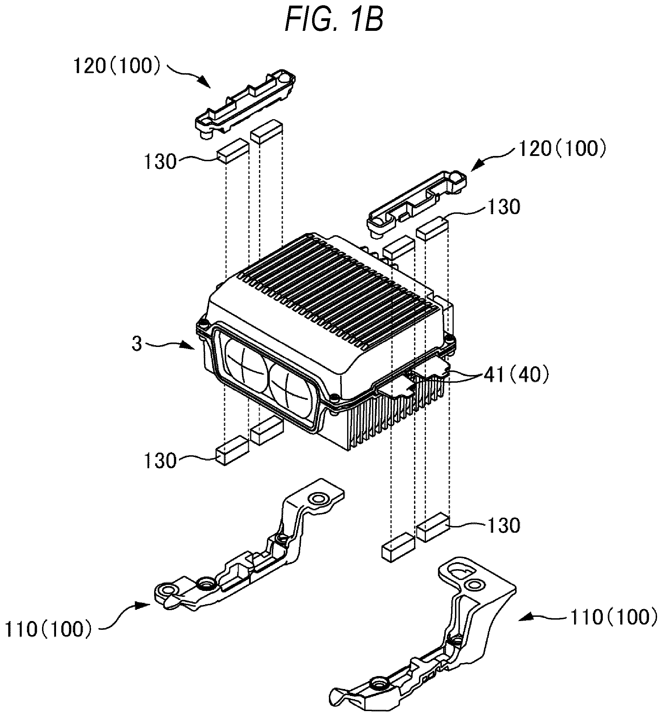

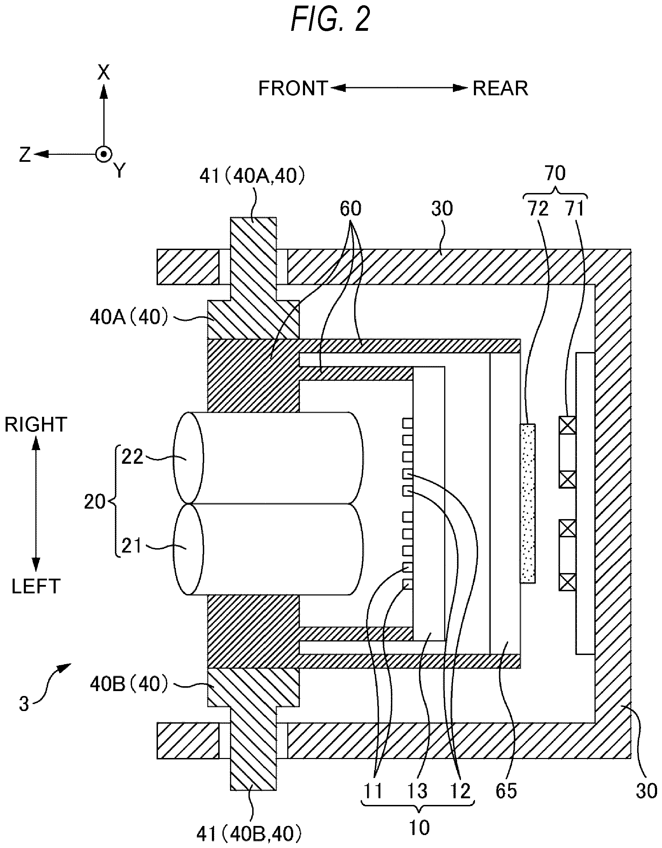

FIG. 1A is a perspective view of a measuring device 1. FIG. 1B is a perspective view of the measuring device 1 in a state where a vehicle body attachment member 100 is removed from a body portion 3. FIG. 2 is a schematic view of the body portion 3.

In the following description, directions are defined as illustrated in FIG. 1A. A direction parallel to an optical axis (rotational symmetry axis of lens) of an optical system (light projecting optical system 21 or light receiving optical system 22) is defined as a Z direction. An object to be measured by the measuring device 1 is separated from the measuring device 1 in the Z direction. A direction perpendicular to the Z direction in which the light projecting optical system 21 and the light receiving optical system 22 are arranged is defined as an X direction. A direction perpendicular to the Z direction and the X direction is defined as a Y direction.

A side of the object to be measured (plus side in Z direction) as viewed from the measuring device 1 may be referred to as "front", and an opposite side (minus side in Z direction) may be referred to as "rear". A right side and a left side when the front is viewed from the rear may be referred to as "right" and "left", respectively. A left-right direction may be referred to as a width direction. An upper side in a vertical direction (plus side in Y direction) may be referred to as "up", and an opposite side (minus side in Y direction) may be referred to as "down".

The measuring device 1 is a device configured to measure a distance to the object. The measuring device 1 is configured to emit laser light, detect reflected light reflected by a surface of the object, and calculate the distance to the object based on a detection result. Specifically, the measuring device 1 is configured to measure time from when pulsed laser light is projected from a light emitting element 11 to when a light receiving element 12 receives the reflected light, thereby measuring the distance to the object by a time of flight (TOF) method. The measuring device 1 includes the body portion 3 and the vehicle body attachment member 100.

The body portion 3 is a member configuring a body of the measuring device 1. The body portion 3 includes a sensor unit 10 and an optical unit 20. In addition, the body portion 3 includes a housing, a holder, a processing substrate, a spring member, a vibration member, and a drive unit.

The sensor unit 10 includes the light emitting element 11, the light receiving element 12, and a sensor substrate 13. The light emitting element 11 is an element configured to emit laser light. The light receiving element 12 is an element configured to convert an optical signal into an electric signal. The sensor substrate 13 is a substrate on which the light emitting element 11 and the light receiving element 12 are mounted. The sensor unit 10 is implemented by mounting the light emitting element 11 and the light receiving element 12 on the same substrate. Here, the sensor substrate 13 includes a plurality of the light emitting elements 11 and a plurality of the light receiving elements 12. However, the sensor substrate 13 may include one light emitting element 11 and one light receiving element 12.

The optical unit 20 is an optical system for irradiating the object with the laser light emitted from the light emitting element 11 and for causing the light receiving element 12 to receive the reflected light from the object. The light emitting element 11 and the light receiving element 12 are disposed at conjugate positions of the optical system configured by the optical unit 20. The optical unit 20 includes the light projecting optical system 21 and the light receiving optical system 22. The light projecting optical system 21 is an optical system configured to irradiate the object with the laser light emitted from the light emitting element 11. A light emitting surface of the light emitting element 11 is disposed in a focal plane of the light projecting optical system 21. The light projecting optical system 21 is configured to irradiate the object with the laser light, as collimated light, emitted from the light emitting element 11. The light receiving optical system 22 is an optical system configured to condense the reflected light on the light receiving element 12. A light receiving surface of the light receiving element 12 is disposed in a focal plane of the light receiving optical system 22. The light projecting optical system 21 and the light receiving optical system 22 are integrally implemented to form the optical unit 20. Here, each of the light projecting optical system 21 and the light receiving optical system 22 includes a plurality of lens groups. Each of the light projecting optical system 21 and the light receiving optical system 22 may include one lens.

The sensor unit 10 and the optical unit 20 move relative to each other in directions (X direction and Y direction) perpendicular to the Z direction. When the sensor unit 10 and the optical unit 20 move relative to each other, a positional relation of the light emitting element 11 with respect to the optical unit 20 changes, and as a result, an angle at which the laser light is emitted changes. That is, the relative movement between the sensor unit 10 and the optical unit 20 allows the laser light to be scanned. The sensor unit 10 moves relative to the optical unit 20 by vibrating at a predetermined resonance frequency in each of the X direction and the Y direction.

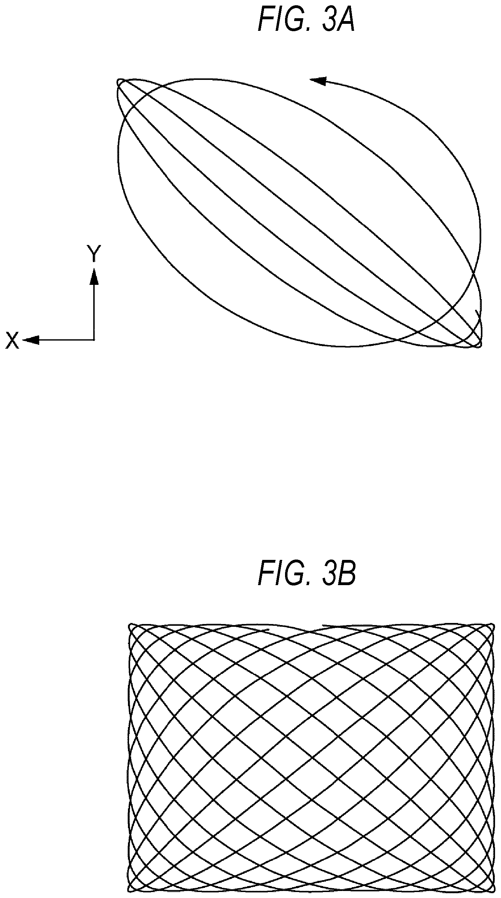

FIG. 3A illustrates two-dimensional scanning of laser light. Laser light is emitted so as to draw a Lissajous curve as illustrated in FIG. 3A by the sensor unit 10 vibrating at a predetermined resonance frequency in the X direction and the Y direction with respect to the optical unit 20.

FIG. 3B illustrates two-dimensional scanning on a certain frame. The measuring device 1 is configured to measure the distance (Z coordinate) to the surface of the object at a plurality of points on the Lissajous curve for each measurement of one frame (one three-dimensional image). Accordingly, the measuring device 1 can improve the resolution in measuring the coordinates.

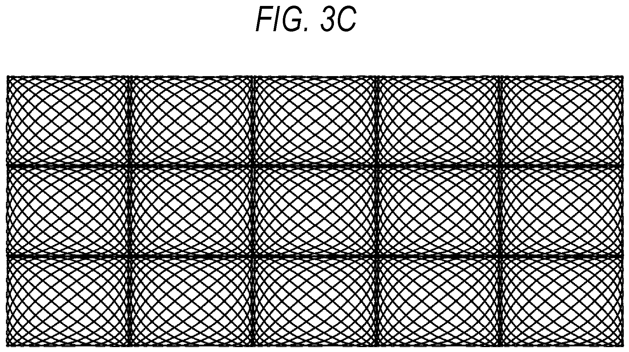

FIG. 3C illustrates two-dimensional scanning by a plurality of channels. As illustrated in FIG. 3C, the sensor substrate 13 includes the plurality of light emitting elements 11 and the plurality of light receiving elements 12, so that two-dimensional scanning may be performed in a different range for each channel. Accordingly, measurement may be performed in a wide range in the X direction and the Y direction, and a wide field of view (FOV) can be implemented.

The two-dimensional scanning may not be performed along the Lissajous curve. For example, two-dimensional scanning may be performed by performing line scanning in the X direction (or Y direction) a plurality of times while shifting in the Y direction (or X direction). In addition, one-dimensional scanning (scanning in one direction of X direction or Y direction) may be performed, instead of two-dimensional scanning.

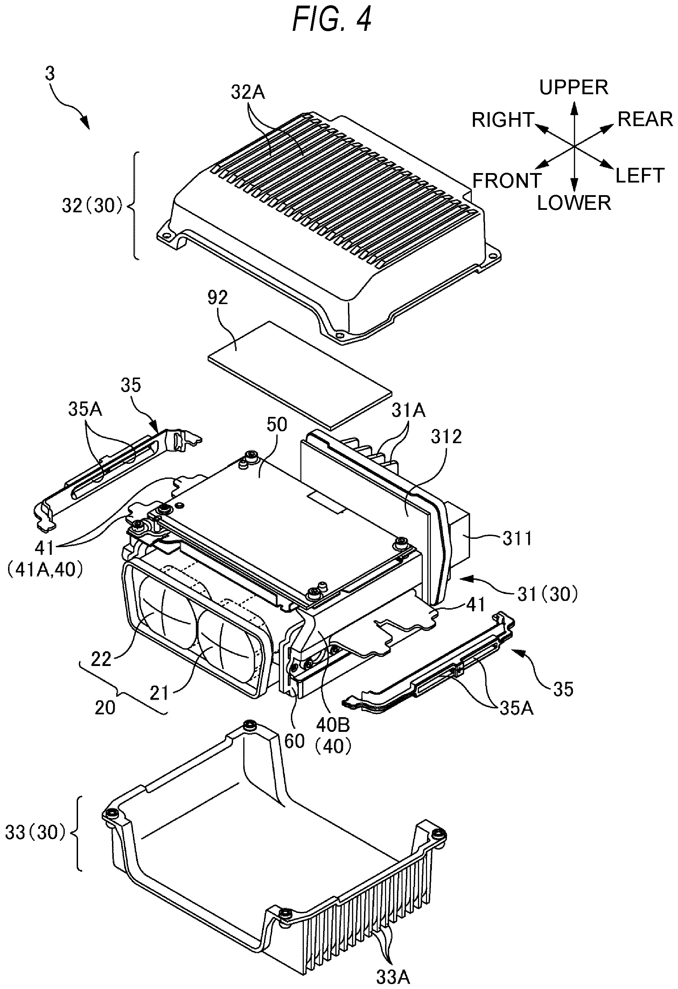

FIG. 4 illustrates a state where the housing 30 is removed. The housing 30 is a member (casing) configured to accommodate the optical unit 20 and the sensor unit 10. The housing 30 includes a rear housing 31, an upper housing 32, and a lower housing 33.

The rear housing 31 covers a rear portion of the body portion 3. The rear housing 31 includes a connector 311 and a coil substrate 312. The connector 311 is a connection portion that is electrically connected to an external power supply or a vehicle ECU. The coil substrate 312 is a substrate for driving a coil 71 (see FIG. 2) of a drive unit 70.

The upper housing 32 covers an upper portion of the body portion 3. The lower housing 33 covers a lower portion of the body portion 3. A gap is formed between the upper housing 32 and the lower housing 33 on a side surface of the housing 30, and a projection portion 41 of the holder 40 is inserted into the gap. A gap between the housing 30 (upper housing 32 and lower housing 33) and the holder 40 is sealed by a gasket 35.

The gasket 35 is a member that seals the gap between the housing 30 (upper housing 32 and lower housing 33) and the holder 40. The gasket 35 is sandwiched between the upper housing 32 and the lower housing 33 on the side surface of the body portion 3. The gasket 35 is formed with an insertion portion 35A through which the projection portion 41 of the holder 40 is inserted. The gasket 35 is made of rubber so as to easily seal the gap between the housing 30 and the holder 40.

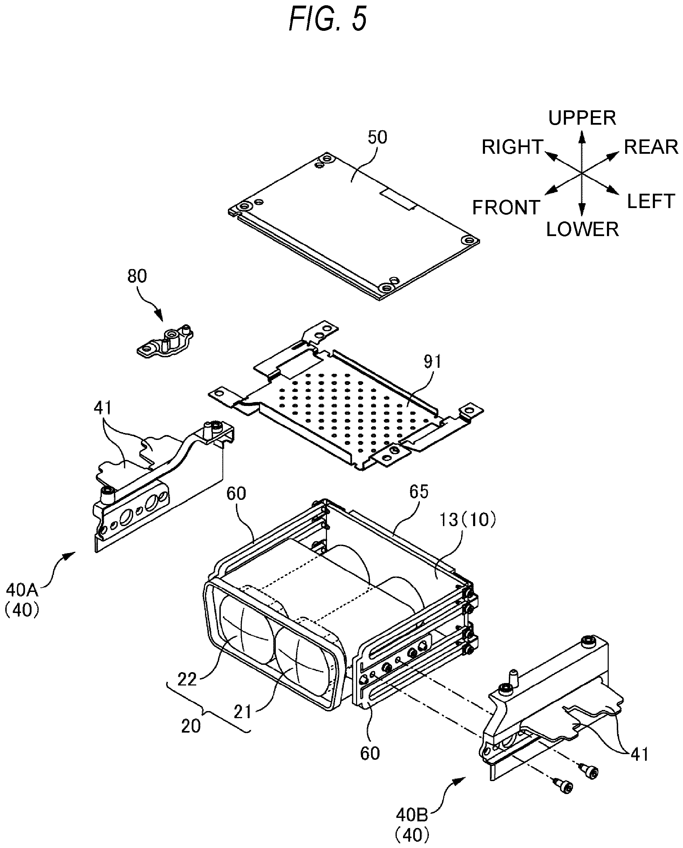

FIG. 5 illustrates a state where the holder 40 and the processing substrate 50 are removed.

The holder 40 is a member configured to hold the sensor unit 10 and the optical unit 20. Here, the holder 40 is fixed to a spring member 60 fixed to the optical unit 20, and indirectly holds the optical unit 20 via the spring member 60. The sensor unit 10 is attached to the spring member 60, and the holder 40 holds the sensor unit 10 and the optical unit 20 in a relatively movable manner. The holder 40 includes a right holder 40A and a left holder 40B. The holder 40 is implemented by two components in the present example, but may be implemented by one component instead. However, since two components of the right holder 40A and the left holder 40B constitute the holder 40, the size of the holder 40 can be reduced.

The holder 40 includes the projection portion 41. The projection portion 41 protrudes outward in the left-right direction from a body of the holder 40. The projection portion 41 is inserted into the gap between the upper housing 32 and the lower housing 33. Accordingly, an end portion of the projection portion 41 protrudes to the outside of the housing 30. The end portion of the projection portion 41 protruding to the outside of the housing 30 is held by the vehicle body attachment member 100. That is, the projection portion 41 is configured to be attached to the vehicle body attachment member 100.

The processing substrate 50 is a substrate configured to perform various types of processing such as control processing and signal processing (arithmetic processing) of the sensor unit 10. A chip (not illustrated in FIG. 5) for controlling a light emission timing of the light emitting element 11 and calculating a distance to the object based on a light reception signal of the light receiving element 12, is mounted on the processing substrate 50. The processing substrate 50 is fixed on the holder 40. One end of the processing substrate 50 is supported by the holder 40 via a support member 80. A shield member 91 is disposed between the processing substrate 50 and the optical unit 20. As illustrated in FIG. 4, a heat transfer sheet 92 is disposed between the processing substrate 50 and the upper housing 32.

The spring member 60 is a member configured to hold the optical unit 20 and the sensor unit 10 in a relatively movable manner. The spring member 60 is configured to hold the sensor unit 10 with respect to the optical unit 20 so as to be able to vibrate at a predetermined resonance frequency in each of the X direction and the Y direction.

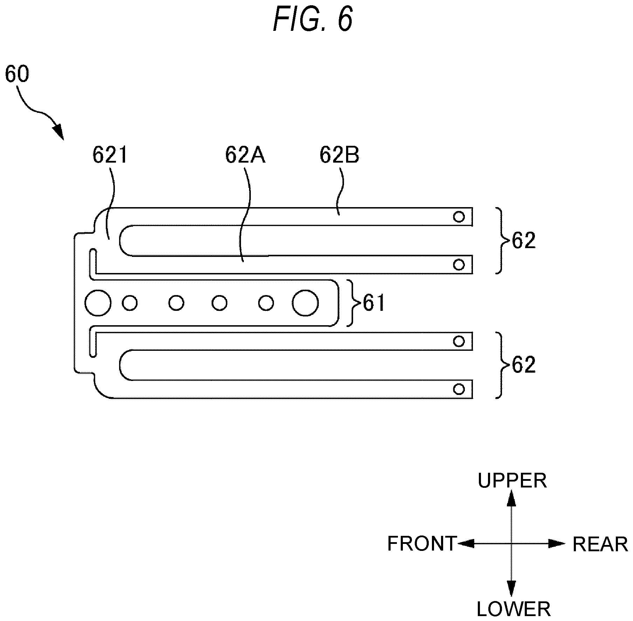

FIG. 6 illustrates the spring member 60.

The spring member 60 includes a stationary portion 61 and a pair of vibration portions 62.

The stationary portion 61 is fixed to the optical unit 20. In addition, the stationary portion 61 is also fixed to the holder 40. The stationary portion 61 has a belt shape (plate shape) along a front-rear direction, and is disposed at the center in an upper-lower direction of the spring member 60.

The vibration portion 62 is configured to vibrate. The vibration portion 62 has a U-shape (tuning fork shape). The vibration portion 62 includes a branch portion 621, a first bending portion 62A, and a second bending portion 62B. The branch portion 621 is a portion between the stationary portion 61 and the first bending portion 62A and the second bending portion 62B, and is a portion that branches the first bending portion 62A and the second bending portion 62B from the stationary portion 61. The first bending portion 62A and the second bending portion 62B are cantilevered portions extending from the branch portion 621, and are portions bent at a predetermined natural frequency. A base end (front end) of the first bending portion 62A is coupled to the branch portion 621, and an opposite end portion (rear end; distal end) is coupled to the sensor unit 10. A base end (front end) of the second bending portion 62B is coupled to the branch portion 621, and an opposite end portion (rear end; distal end) is coupled to a vibration member 65. The vibration portion 62 including the first bending portion 62A and the second bending portion 62B vibrates in a predetermined vibration mode, so that the sensor unit 10 vibrates at a predetermined resonance frequency in each of the X direction and the Y direction with respect to the optical unit 20.

The stationary portion 61 of the spring member 60 is disposed between the pair of vibration portions 62. Therefore, since the vibration of the pair of vibration portions 62 is cancelled out at the stationary portion 61, the stationary portion 61 is unlikely to vibrate even during a relative movement between the optical unit 20 and the sensor unit 10.

The vibration member 65 is a member for causing the sensor unit 10 to resonate. The vibration member 65 is held by the spring member 60. The second bending portions 62B of the spring member 60 are coupled to left and right edges of the vibration member 65. The vibration member 65 is configured to receive forces in the X direction and the Y direction from the drive unit 70, so that the sensor unit 10 resonates via the spring member 60. As a result, the sensor unit 10 moves relative to the optical unit 20 in the X direction and the Y direction.

The drive unit 70 is a member (motor) configured to generate a driving force for relatively moving the optical unit 20 and the sensor unit 10. The drive unit 70 includes the coil 71 and a magnet 72 (see FIG. 2). Here, the coil 71 is fixed to the housing 30 (rear housing 31) and configures a stator. The magnet 72 is fixed to the vibration member 65 and configures a mover. The magnet 72 may configure a stator, and the coil 71 may configure a mover. However, wiring to the coil 71 in a case where the coil 71 configures a stator is easier than that in a case where the coil 71 configures a mover. In addition, the drive unit 70 is not limited to the motor including the coil 71 and the magnet 72, and may be implemented by another actuator such as a piezoelectric transducer.

The vehicle body attachment member 100 is a member configured to attach the body portion 3 to the vehicle body (see FIGS. 1A and 1B). A pair of the vehicle body attachment members 100 are disposed to the left and right of the body portion 3. The pair of vehicle body attachment members 100 hold the respective projection portions 41 of the holder 40 protruding from left and right side surfaces of the body portion 3. Each of the vehicle body attachment members 100 includes a first attachment member 110 and a second attachment member 120. The body portion 3 is held by the vehicle body attachment member 100 by the projection portion 41 of the holder 40 being sandwiched between the first attachment member 110 and the second attachment member 120. A damper member 130 is disposed between the first attachment member 110 and the holder 40 and between the second attachment member 120 and the holder 40. The damper member 130 is a rubber member that absorbs vibration. Since the vehicle body attachment member 100 holds the holder 40 via the damper member 130, transmission of vibration of the body portion 3 to the vehicle body can be reduced.

### <Fixing Structure of Processing Substrate 50>

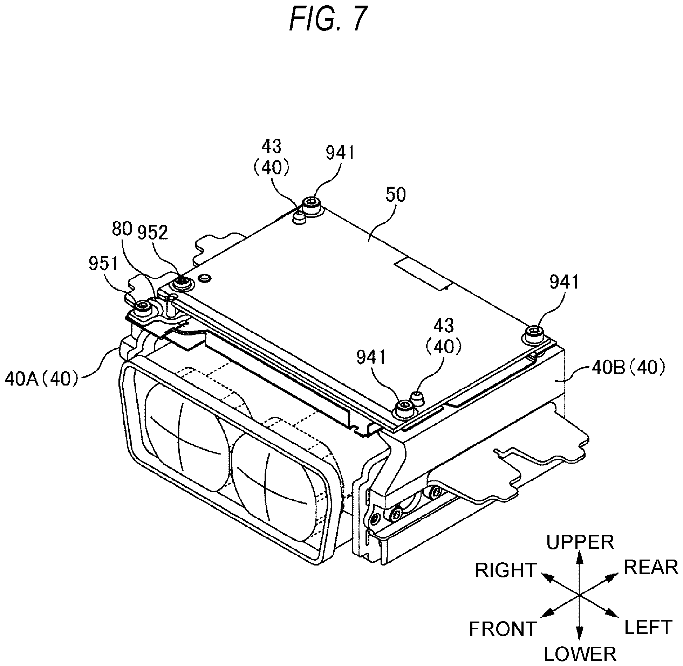

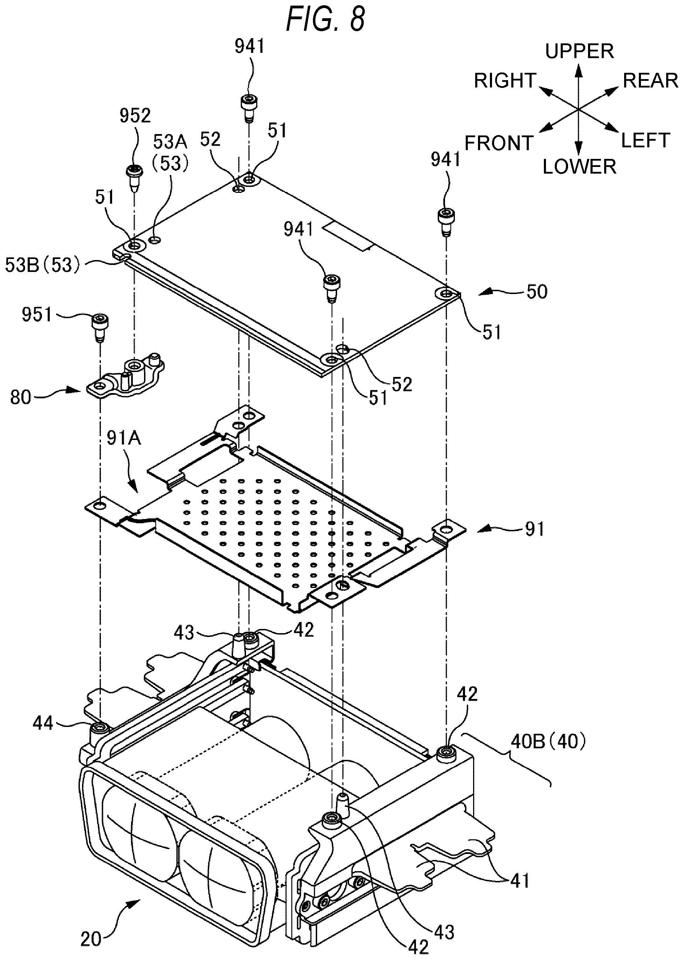

FIG. 7 illustrates the processing substrate 50 fixed on the holder 40. FIG. 8 illustrates a state where the processing substrate 50 (and shield member 91) are removed from the holder 40.

The holder 40 includes a fixing portion 42, an alignment pin 43, and an attachment portion 44. The processing substrate 50 includes a hole 51 for fixing and an alignment hole 52.

The fixing portion 42 is a portion for fixing the processing substrate 50. Here, the fixing portion 42 is implemented by a screw hole. A fixing screw 941 inserted through the hole 51 of the processing substrate 50 is fastened to the fixing portion 42, so that the processing substrate 50 is fixed to the fixing portion 42. The fixing portion 42 is also a portion for fixing the shield member 91.

The holder 40 includes three fixing portions 42. Here, one fixing portion 42 is provided on the right holder 40A, and two fixing portions 42 are provided on the left holder 40B. However, two fixing portions 42 may be provided on the right holder 40A, and one fixing portion 42 may be provided on the left holder 40B. The hole 51 for fixing is disposed at four corners of the processing substrate 50, and three corners among the four corners are fixed to the holder 40. In a case where the four corners of the processing substrate 50 are fixed to the holder 40, an excessive load may be applied to the processing substrate 50 due to an influence of a dimensional tolerance because there are many fixing portions. Therefore, in the present embodiment, three portions of the processing substrate 50 are fixed to the holder 40.

The alignment pin 43 is a portion for aligning the holder 40 with the processing substrate 50. By fitting the alignment pin 43 of the holder 40 into the alignment hole 52 of the processing substrate 50, the holder 40 and the processing substrate 50 can be aligned with each other, and the processing substrate 50 can be fixed at a predetermined position with respect to the holder 40. Here, one alignment pin 43 is provided on each of the right holder 40A and the left holder 40B. In a case where the holder 40 includes two components in this manner, it is desirable that the alignment pin 43 is provided on each of the components constituting the holder 40. However, the alignment pin 43 may be provided only on one holder 40. In addition, the holder 40 may not include the alignment pin 43. The alignment pin 43 is also a portion for aligning the shield member 91.

The attachment portion 44 is a portion for fixing the support member 80 (to be described later). Here, the attachment portion 44 is implemented by a screw hole. The attachment portion 44 is also a portion for fixing the shield member 91 together with the fixing portion 42.

As described above, since the processing substrate 50 is fixed to the holder 40 that holds the sensor unit 10 and the optical unit 20 that move relative to each other, the processing substrate 50 may vibrate. In addition, as described above, merely by fixing three corners of the processing substrate 50 to the holder 40, an unfixed corner may vibrate, and vibration of the processing substrate 50 may cause abnormal noise. Therefore, in the present embodiment, the vibration of the processing substrate 50 is suppressed by supporting the unfixed portion of the processing substrate 50 by the support member 80.

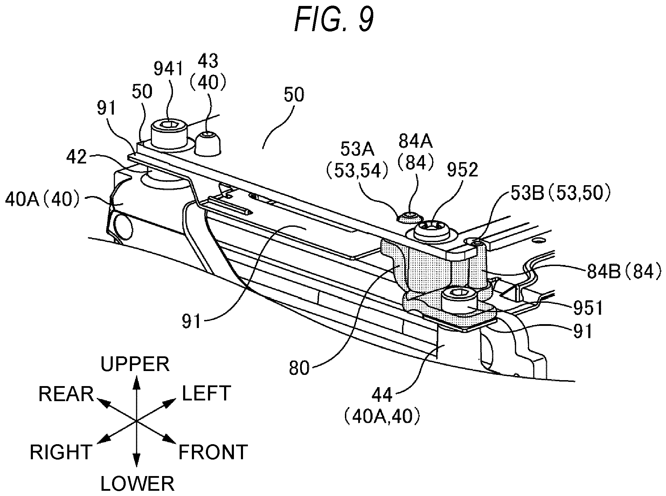

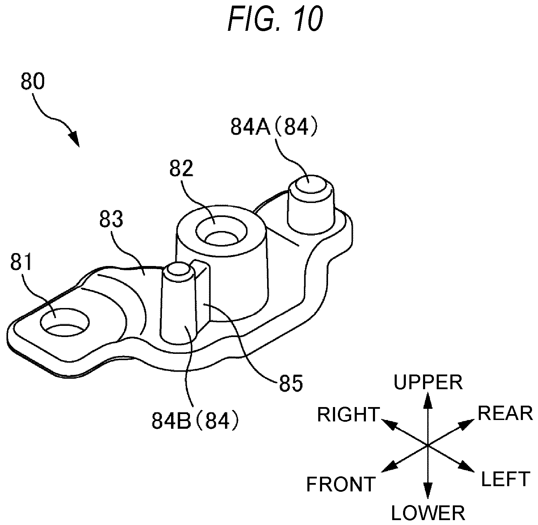

FIG. 9 illustrates a state where the support member 80 supports the processing substrate 50. FIG. 10 is a perspective view of the support member 80. For the purposes of description, the support member 80 in FIG. 9 is hatched.

The support member 80 is a member configured to support the processing substrate 50. The support member 80 is an elastically deformable portion. The support member 80 is deformed while supporting an end portion of the processing substrate 50, so that the support member 80 can absorb the vibration of the processing substrate 50 and reduce the vibration of the processing substrate 50.

The support member 80 is made of resin. The support member may be made of a material (for example, metal) other than resin as long as it is elastically deformable. The support member 80 is made of a member softer than the processing substrate 50. In other words, the support member 80 is formed of a member that is more easily elastically deformed in the upper-lower direction than the processing substrate 50. Accordingly, since the support member 80 is easily deformed when a load (particularly, load in upper-lower direction) is applied to the processing substrate 50, it is possible to prevent an excessive load from being applied to the processing substrate 50.

The support member 80 includes a first fixing portion 81, a second fixing portion 82, and a coupling portion 83.

The first fixing portion 81 is a portion for fixing the support member 80 to the holder 40. Here, the first fixing portion 81 is implemented by a through hole. The support member 80 is fixed to the holder 40 by fastening a first fixing screw 951 inserted through the first fixing portion 81 to the attachment portion 44 of the holder 40.

The second fixing portion 82 is a portion for fixing the support member 80 to the processing substrate 50. Here, the second fixing portion 82 is implemented by a screw hole. The processing substrate 50 is fixed to the support member 80 by fastening a second fixing screw 952 inserted through the hole 51 of the processing substrate 50 (hole provided at corner portion not fixed to holder 40) to the second fixing portion 82.

The coupling portion 83 is a portion that couples the first fixing portion 81 and the second fixing portion 82. The coupling portion 83 is an elastically deformable portion. The coupling portion 83 is elastically deformed between the first fixing portion 81 and the second fixing portion 82. Elastic deformation of the coupling portion 83 allows displacement of the processing substrate 50 with respect to the holder 40. Accordingly, the support member 80 can absorb the vibration of the processing substrate 50 and can reduce the vibration of the processing substrate 50.

In addition, the coupling portion 83 includes a plate-shaped portion extending from the first fixing portion 81 in a direction (horizontal direction) perpendicular to the upper-lower direction, and allows the second fixing portion 82 to be displaced in the upper-lower direction with respect to the first fixing portion 81. Accordingly, it is possible to absorb the vibration in the upper-lower direction of the unfixed end portion of the processing substrate 50 and to suppress the vibration in the upper-lower direction of the end portion of the processing substrate 50.

In addition, the support member 80 includes an alignment pin 84 (84A and 84B). The alignment pin 84 is a portion for aligning the support member 80 with the processing substrate 50. By fitting the alignment pin 84 of the support member 80 into an alignment portion 53 (reference hole 53A and long hole 53B to be described later) of the processing substrate 50, the support member 80 and the processing substrate 50 can be aligned with each other, and the support member 80 can be fixed at a predetermined position with respect to the processing substrate 50.

The support member 80 includes a first pin 84A and a second pin 84B, as the alignment pin 84. The processing substrate 50 includes the reference hole 53Aand the long hole 53B, as the alignment portion 53.

The first pin 84A is an alignment pin to be fitted into the reference hole 53A of the processing substrate 50. The second pin 84B is an alignment pin to be fitted into the long hole 53B of the processing substrate 50. The reference hole 53A is a hole into which the first pin 84A is fitted. The reference hole 53A is a hole having a circular cross section. The long hole 53B is a hole into which the second pin 84B is fitted. The long hole 53B is a hole extending toward the reference hole 53A. By forming a hole fitted into one of two alignment pins 84 (first pin 84A and second pin 84B) as the long hole 53B, each of two alignment pins 84 (84A and 84B) can be fitted into the alignment portion 53 even when there is a tolerance.

Here, the long hole 53B is provided at a peripheral edge of the processing substrate 50. Therefore, the long hole 53B is implemented as a concave portion (notch) recessed from the peripheral edge of the processing substrate 50. In other words, the long hole 53B has a shape opened at the peripheral edge of the processing substrate 50. Accordingly, it is possible to reduce the size of the processing substrate 50 as compared with a case where the long hole 53B is disposed inside the peripheral edge of the processing substrate 50 (case where long hole 53B has closed shape). However, the long hole 53B may have a closed shape by disposing the long hole 53B inside the peripheral edge of the processing substrate 50. In addition, the support member 80 may not include the alignment pin 84, and the processing substrate 50 may not include the alignment portion 53 (reference hole 53A and long hole 53B).

The second fixing portion 82 of the support member 80 is disposed between the two alignment pins 84 (first pin 84A and second pin 84B). Accordingly, when the support member 80 is fixed to the processing substrate 50 at the second fixing portion 82, the two alignment pins 84 (first pin 84A and second pin 84B) are hardly detached from the alignment portions 53 of the processing substrate 50. However, the second fixing portion 82 may not be disposed between the two alignment pins 84.

A rib 85 is provided between the second fixing portion 82 and the alignment pin 84 (specifically, second pin 84B). Since the second fixing portion 82 and the alignment pin 84 are integrated by the rib 85, a positional relation between the second fixing portion 82 and the alignment pin 84 is hardly changed even when the support member 80 (specifically, coupling portion 83) is elastically deformed. Accordingly, even when the support member 80 (specifically, coupling portion 83) is elastically deformed, the alignment pin 84 is hardly detached from the alignment portion 53 of the processing substrate 50. However, the rib 85 may not be provided between the second fixing portion 82 and the alignment pin 84.

### <Regarding Shield Member 91>

The shield member 91 is an electromagnetic wave shield (electromagnetic shield member) made of a conductive material. Here, the shield member 91 is formed by bending a metal plate, but may be formed of another material.

The shield member 91 is disposed between the processing substrate 50 and the optical unit 20. The shield member 91 prevents the electromagnetic wave generated in the processing substrate 50 from leaking to the outside or prevents the processing substrate 50 from being affected by the electromagnetic wave from the outside. In order to emit light from the optical unit 20 and to receive reflected light from the optical unit 20, the housing 30 of the measuring device 1 accommodates the sensor unit 10, the optical unit 20, and the processing substrate 50 while exposing a light incident and emission surface of the optical unit 20. Due to the structure of the measuring device 1, electromagnetic waves may leak or enter through the optical unit 20. Therefore, it is effective to dispose the shield member 91 between the processing substrate 50 and the optical unit 20.

The shield member 91 is fixed to the holder 40 together with the processing substrate 50 and the support member 80. Similarly to the processing substrate 50, the shield member 91 has a hole for fixing. The shield member 91 is fixed together with the processing substrate 50 by fastening the fixing screw 941 inserted into the hole of the shield member 91 to the fixing portion 42 of the holder 40. In addition, the shield member 91 is fixed together with the support member 80 by fastening the first fixing screw 951 inserted through the hole of the shield member 91 to the attachment portion 44 of the holder 40. In this manner, the fixing portion 42 and the attachment portion 44 of the holder 40 have not only a function of fixing the processing substrate 50 but also a function of fixing the shield member 91. Accordingly, since the shield member 91 can be fixed without increasing the number of fixing portions 42 of the holder 40, the size of the holder 40 and the measuring device 1 can be reduced. However, a portion for fixing the processing substrate 50 and a portion for fixing the shield member 91 may be separately provided.

In addition, an alignment hole is formed in the shield member 91, similarly to the processing substrate 50. By fitting the alignment pin 43 of the holder 40 into the alignment hole of the shield member 91, the shield member 91 can be aligned with the holder 40 together with the processing substrate 50. In this manner, the alignment pin 43 of the holder 40 has not only a function of aligning the processing substrate 50 but also a function of aligning the shield member 91. Accordingly, the shield member 91 can be aligned without increasing the number of the alignment pin 43 of the holder 40, and therefore, the size of the holder 40 and the measuring device 1 can be reduced. However, a portion for aligning the processing substrate 50 and a portion for aligning the shield member 91 may be separately provided.

When the shield member 91 is fixed to the holder 40 together with the processing substrate 50, it is desirable that the shield member 91 includes an escape portion 91A (see FIG. 8). The escape portion 91A is a concave-shaped portion for avoiding contact with the support member 80. By providing the escape portion 91A at the shield member 91, it is possible to prevent the deformed support member 80 from coming into contact with the shield member 91. However, the shield portion may not include the escape portion 91A.

### <Regarding Heat Radiation>

The heat transfer sheet 92 (see FIG. 4) is a sheet-shaped member for promoting heat radiation of the processing substrate 50. The heat transfer sheet 92 is disposed between the processing substrate 50 and the upper housing 32. The heat transfer sheet 92 is configured to transfer heat of the processing substrate 50 to the upper housing 32. The heat transfer sheet 92 is sandwiched between the processing substrate 50 and the upper housing 32 and compressed in a thickness direction. The heat transfer sheet 92 has a higher thermal conductivity at a compressed portion. However, in a case where a compressive stress is applied to the heat transfer sheet 92, a load is applied to the processing substrate 50.

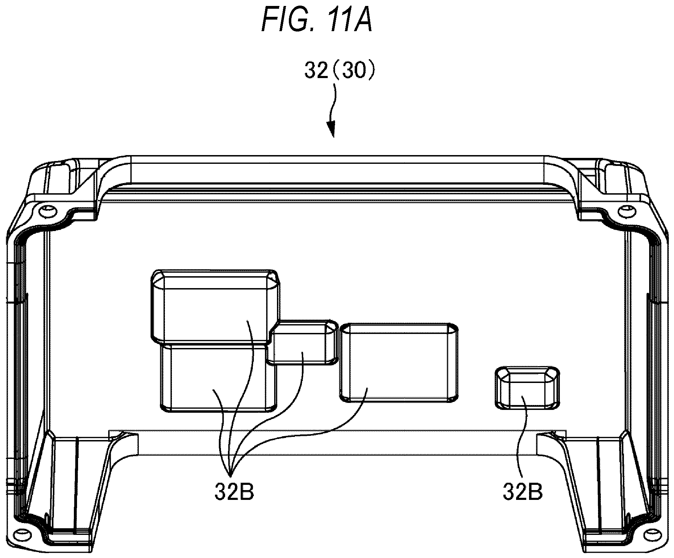

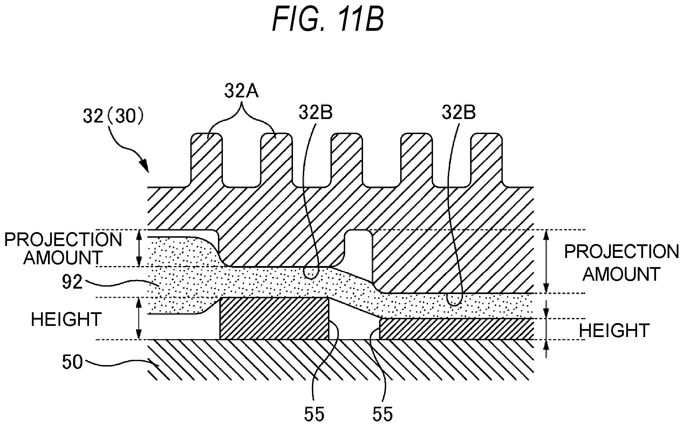

FIG. 11A illustrates an inner wall surface of the upper housing 32. FIG. 11B is a cross section illustrating a relation between a projection amount of a convex portion 32B of the upper housing 32 and a height of a chip 55.

As illustrated in FIG. 11A, the housing 30 (here, upper housing 32) includes a plurality of convex portions 32B. The convex portion 32B is a portion configured to compress the heat transfer sheet 92. The convex portion 32B is a convex-shaped portion provided on the inner wall surface of the housing 30 and protrudes toward the substrate. In other words, the convex portion 32B is a portion protruding downward from the inner wall surface of the housing 30. A compression ratio of the heat transfer sheet 92 is high at a portion where the convex portion 32B is provided.

The convex portion 32B is disposed to face the chip 55 (semiconductor element) mounted on the substrate. By disposing the convex portion 32B to face the chip 55, it is possible to increase the compression ratio of the heat transfer sheet 92 in a region in contact with the chip 55. Accordingly, the heat of the chip 55 is easily radiated.

As illustrated in FIG. 11B, the heat transfer sheet 92 is sandwiched between the chip 55 of the processing substrate 50 and the convex portion 32B of the upper housing 32. In addition, the heat transfer sheet 92 is compressed in the thickness direction between the chip 55 and the convex portion 32B.

As illustrated in FIGS. 11A and 11B, projection amounts of the plurality of convex portions 32B are different from one another. The projection amount of the convex portion 32B varies depending on the height of the chip 55 facing the convex portion 32B. Specifically, as illustrated in FIG. 11B, the projection amount of the convex portion 32B is set to be larger as the facing chip 55 is lower. In other words, the sum of the projection amount of the convex portion 32B and the height of the chip 55 is set to be substantially constant. Accordingly, the compression ratio of the heat transfer sheet 92 can be made uniform in any chip 55.

Instead of making the projection amounts of the plurality of convex portions 32B different from one another, it is considered that the projection amounts of all the convex portions 32B are set to be large in accordance with the chip 55 having the lowest height to improve heat dissipation properties of all the chips 55 (or it is considered that the inner wall surface of the upper housing 32 is lowered). However, in this case, the compression ratio of the heat transfer sheet 92 increases between the chip 55 having a high height and the convex portion 32B, and as a result, a pressing force is applied to the processing substrate 50 at a position of the chip 55 having a high height. Therefore, a load may be applied to the processing substrate 50.

On the other hand, it is considered to set the projection amounts of all the convex portions 32B to be small in accordance with the chip 55 having the highest height (or it is considered to increase the height of the inner wall surface of the upper housing 32), in order to suppress the load on the processing substrate 50. However, in this case, the compression ratio of the heat transfer sheet 92 becomes low between the chip 55 having a low height and the convex portion 32B, and as a result, the heat radiation of the chip 55 having a low height may become insufficient.

In contrast, in the present embodiment, the projection amount of the convex portion 32B is set to be larger as the height of the chip 55 facing the convex portion 32B is lower. Therefore, it is possible to implement both suppression of the load applied to the processing substrate 50 by suppressing the pressing force applied to the chip 55 and improvement of the heat dissipation properties of the chip 55.

Further, in a structure in which the processing substrate 50 is fixed to the holder 40 and is not fixed to the upper housing 32 as in the present embodiment, a dimensional tolerance of a gap between the processing substrate 50 and the upper housing 32 is large (because a dimensional tolerance of a gap between the processing substrate 50 and the upper housing 32 is an integrated value of a dimensional tolerance or an attachment error of each member). Therefore, when the projection amounts of all the convex portions 32B are temporarily set to be the same, a pressing force may be applied to the processing substrate 50 at the position of the chip 55 having a high height and a load may be applied to the processing substrate 50 in a case where the gap between the processing substrate 50 and the upper housing 32 is narrowed to the minimum in a range of the dimensional tolerance. In addition, when the projection amounts of all the convex portions 32B are temporarily set to be the same, the heat radiation of the chip 55 having a low height may be insufficient in a case where the gap between the processing substrate 50 and the upper housing 32 is maximized within the range of the dimensional tolerance. In this manner, when the projection amounts of all the convex portions 32B are temporarily set to be the same, it is difficult to appropriately set the compression ratio of the heat transfer sheet 92 in the entire range of the dimensional tolerance of the gap between the processing substrate 50 and the upper housing 32. Therefore, the structure in which the projection amount of the convex portion 32B increases as the height of the facing chip 55 decreases as in the present embodiment is particularly effective when the processing substrate 50 is fixed to the holder 40 and is not fixed to the upper housing 32 (in other words, when the dimensional tolerance of the gap between the processing substrate 50 and the upper housing 32 increases).

As described above, the heat generated in the processing substrate 50 is transferred to the upper housing 32 via the heat transfer sheet 92. Therefore, it is desirable that the upper housing 32 includes a heat radiation fin 32A. As illustrated in FIG. 11B, it is desirable that the heat radiation fin 32A of the upper housing 32 is provided on a back surface of the inner wall surface of the upper housing 32 in a region in contact with the heat transfer sheet 92. In particular, it is desirable that the heat radiation fin 32A of the upper housing 32 is provided on the back surface of the portion where the convex portion 32B is provided. The heat radiation fin 32A may be provided at another portion of the upper housing 32. In addition, the upper housing 32 may not include the heat radiation fin 32A.

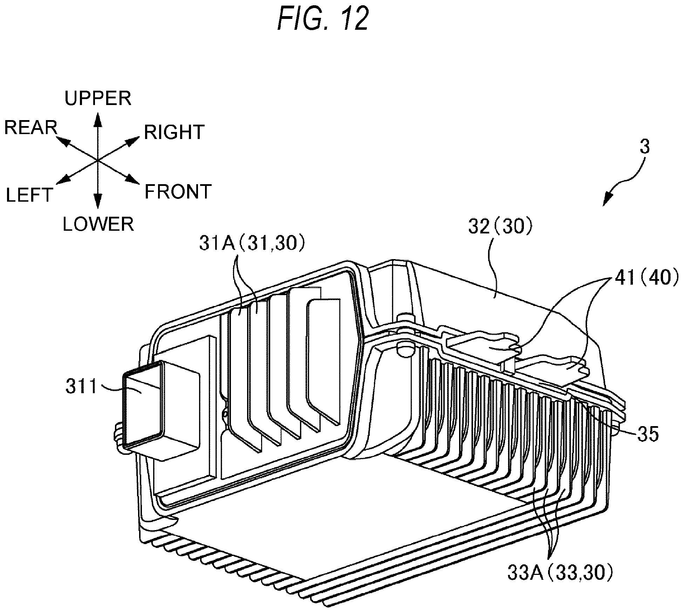

FIG. 12 is a perspective view of the body portion 3 as viewed from another angle. In this manner, it is desirable that the heat radiation fin (31A, 33A) is provided not only on the upper housing 32 but also on the rear housing 31 and the lower housing 33. Accordingly, heat in an internal space of the housing 30 and heat transferred from the upper housing 32 via the heat transfer sheet 92 are easily dissipated to the outside. A heat radiation fin may be provided at another portion of the rear housing 31 and the lower housing 33. In addition, the rear housing 31 and the lower housing 33 may not include the heat radiation fin (31A, 33A).

### <Summary>

As described above, the measuring device 1 includes the sensor unit 10, the optical unit 20, the holder 40, and the processing substrate 50. The sensor unit 10 includes the light emitting element 11 configured to emit light and the light receiving element 12 configured to receive reflected light. The optical unit 20 is configured to irradiate an object with the light emitted from the light emitting element 11 and configured to cause the light receiving element 12 to receive the reflected light. The holder 40 is configured to hold the sensor unit 10 and the optical unit 20 in a relatively movable manner. The processing substrate 50 is a substrate fixed to the holder 40. In a case of the measuring device 1 having such a configuration, the processing substrate 50 is fixed to the holder 40 that holds the sensor unit 10 and the optical unit 20 which move relative to each other, and therefore, the processing substrate 50 may vibrate. Therefore, the measuring device 1 according to the present embodiment includes the support member 80 that is deformable and supports an end portion of the processing substrate 50 from the holder 40. Accordingly, the support member 80 is deformed while supporting the end portion of the processing substrate 50, so that the support member 80 can absorb vibration of the processing substrate 50 and reduces the vibration of the processing substrate 50.

It is desirable that the processing substrate 50 is fixed to the holder 40 at three corners of four corners of the processing substrate 50. When the four corners of the processing substrate 50 are temporarily fixed to the holder 40, an excessive load may be applied to the processing substrate 50 due to an influence of a dimensional tolerance because there are many fixing portions. On the other hand, merely by fixing three portions of the processing substrate 50 to the holder 40, an unfixed corner portion may vibrate, and vibration of the processing substrate 50 may cause abnormal noise. Therefore, in the present embodiment, the processing substrate 50 is supported from the holder 40 by the support member 80 at a corner portion of the processing substrate 50 not fixed to the holder 40. Accordingly, it is possible to reduce the vibration of the processing substrate 50 while suppressing the load applied to the processing substrate 50.

The support member 80 includes the first fixing portion 81 fixed to the holder 40, the second fixing portion 82 fixed to the substrate, and the coupling portion 83 that is deformable while coupling the first fixing portion 81 and the second fixing portion 82 (see FIG. 10). Elastic deformation of the coupling portion 83 allows displacement of the processing substrate 50 with respect to the holder 40, and accordingly, makes it possible to suppress the vibration of the processing substrate 50. However, the support member 80 is not limited to the structure illustrated in FIG. 10, and may have any structure as long as the support member 80 is deformable while supporting the end portion of the processing substrate 50 from the holder 40.

It is desirable that the support member 80 includes the alignment pin 84, and that the processing substrate 50 includes the alignment portion 53 to be aligned with the alignment pin 84 of the support member 80. Accordingly, the support member 80 can be fixed at a predetermined position with respect to the processing substrate 50.

In addition, it is desirable that the alignment portion 53 of the processing substrate 50 is a concave portion at a peripheral edge. Accordingly, it is possible to reduce the size of the processing substrate 50 as compared with a case where the long hole 53B is disposed inside the peripheral edge of the processing substrate 50 (case where long hole 53B has closed shape).

The measuring device 1 includes the housing 30, and the housing 30 accommodates the sensor unit 10, the optical unit 20, and the processing substrate 50 while exposing a light incident and emission surface of the optical unit 20. Due to the structure of the measuring device 1, electromagnetic waves may leak or enter through the optical unit 20. Therefore, in the measuring device 1 according to the present embodiment, an electromagnetic shield is disposed between the processing substrate 50 and the optical unit 20. Accordingly, the electromagnetic wave generated in the processing substrate 50 can be suppressed from leaking to the outside, or the processing substrate 50 can be prevented from being affected by the electromagnetic wave from the outside. However, the measuring device 1 may not include the shield member 91.

In the measuring device 1, the heat transfer sheet 92 is sandwiched between the processing substrate 50 and the housing 30. Accordingly, heat of the processing substrate 50 is easily transferred to the housing 30. However, the measuring device 1 may not include the heat transfer sheet 92.

In the measuring device 1, the processing substrate 50 includes a plurality of chips 55 having different heights, the housing 30 includes a plurality of convex portions 32B protruding toward the chips 55, a projection amount of the convex portion 32B is set to be larger as the facing chip 55 is lower, and the heat transfer sheet 92 is compressed in a thickness direction between the chip 55 and the convex portion 32B. Accordingly, the compression ratio of the heat transfer sheet 92 can be made uniform in any chip 55. However, the projection amounts of the plurality of convex portions 32B of the housing 30 may be the same, or the convex portion 32B may not be provided in the housing 30.

In addition, it is desirable that the housing 30 includes the heat radiation fin 32A on an outer surface thereof. Accordingly, the measuring device 1 has a structure that facilitates heat dissipation to the outside. However, a heat radiation fin may not be provided on the housing 30.

### <Disposing and Fixing of Holder 40>

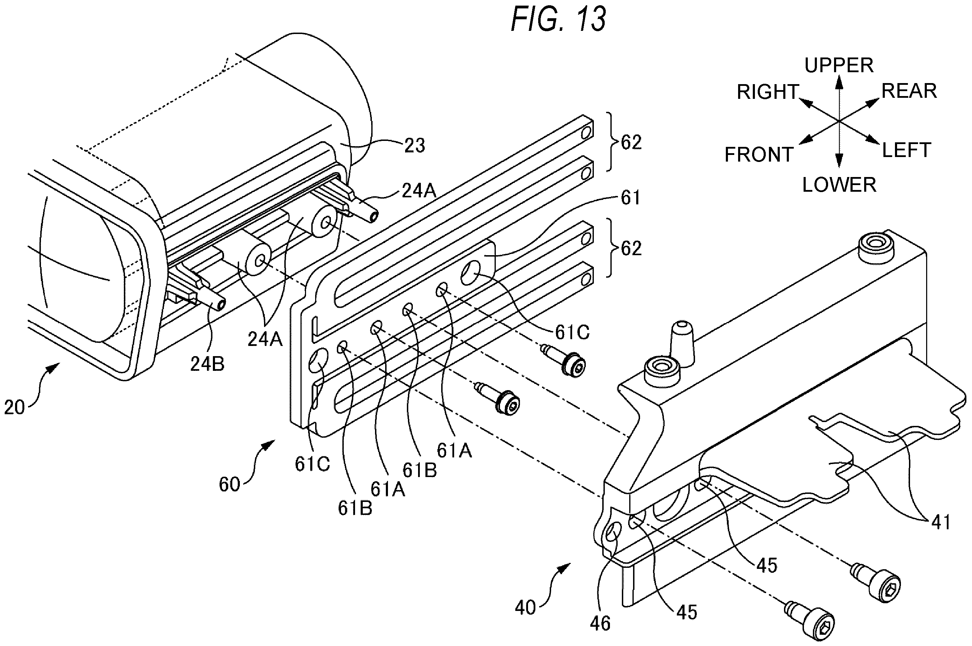

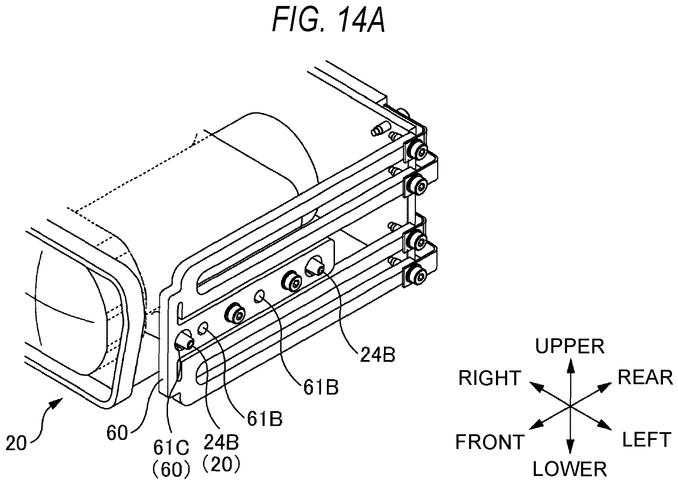

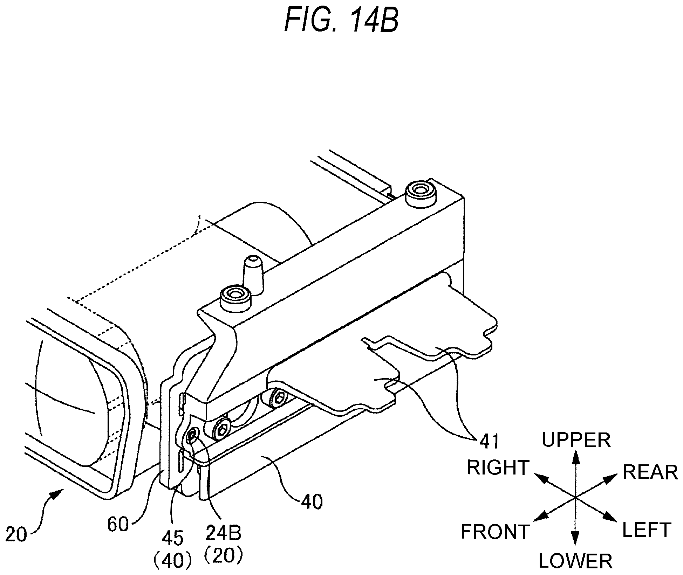

FIG. 13 is an exploded view illustrating the optical unit 20, the spring member 60, and the holder 40. FIG. 14A illustrates a state before the holder 40 is attached. FIG. 14B illustrates a state after the holder 40 is attached.

The optical unit 20 includes a lens housing 23 (lens barrel) that accommodates a lens. A fixing portion 24A and an alignment pin 24B are provided on a side surface of the lens housing 23. The fixing portion 24A is a portion (screw hole) where the spring member 60 is fixed to the optical unit 20 (lens housing 23). The alignment pin 24B is a portion for aligning the spring member 60 (and holder 40).

The stationary portion 61 of the spring member 60 is formed with a first hole 61A, a second hole 61B, and an alignment hole 61C. The first hole 61A is a hole (through hole) through which the spring member 60 is screwed to the optical unit 20. The second hole 61B is a hole through which the holder 40 is screwed. The alignment hole 61C is a hole through which the spring member 60 is aligned with the optical unit 20. The alignment pin 24B of the optical unit 20 is inserted into the alignment hole 61C of the spring member 60, so that the optical unit 20 and the spring member 60 are aligned.

The holder 40 includes a fixing portion 45. An alignment hole 46 is formed in the holder 40. The fixing portion 45 is a portion for screwing the holder 40 to the spring member 60. The alignment hole 46 is a hole through which the holder 40 is aligned with the optical unit 20. The alignment pin 24B of the optical unit 20 is inserted into the alignment hole 46 of the holder 40, so that the optical unit 20 and the spring member 60 are aligned.

As described above, the spring member 60 includes the stationary portion 61 and the vibration portion 62 (see FIG. 6). As illustrated in FIG. 14A, the stationary portion 61 of the spring member 60 is attached to the optical unit 20, and the sensor unit 10 (or vibration member 65) is attached to an end portion (rear end; distal end) of the vibration portion 62. Accordingly, the spring member 60 is configured to hold the sensor unit 10 to be movable relative to the optical unit 20. In such a structure, in a case where the holder 40 is temporarily attached to a vibrating portion such as the vibration portion 62, the holder 40 vibrates, and as a result, vibration of the holder 40 may be transmitted to the vehicle body.

Therefore, in the present embodiment, the holder 40 is attached to the stationary portion 61 of the spring member 60. As described above, the stationary portion 61 is disposed between the pair of vibration portions 62, and vibration of the pair of vibration portions 62 is cancelled at the stationary portion 61. Therefore, the stationary portion 61 is a portion that is hard to vibrate even during the relative movement between the optical unit 20 and the sensor unit 10. Therefore, since the vibration of the holder 40 can be suppressed by attaching the holder 40 to the stationary portion 61 of the spring member 60, transmission of the vibration to the vehicle body can be suppressed.

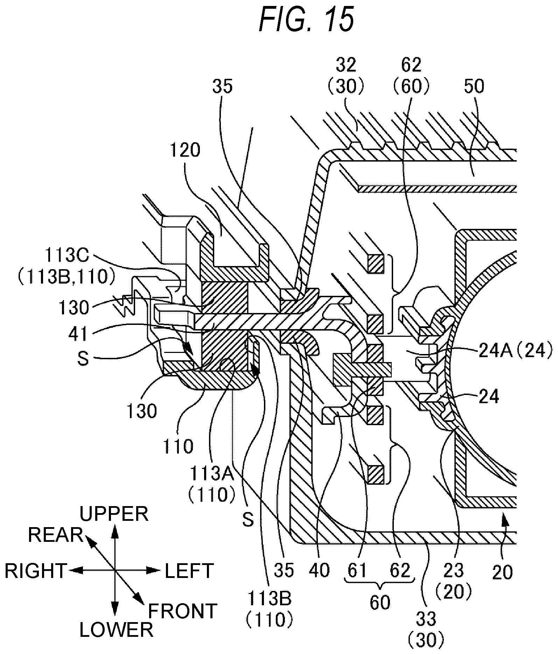

FIG. 15 is a cross sectional view of the measuring device 1. FIG. 15 illustrates a state where the vehicle body attachment member 100 holds the holder 40.

Since the housing 30 accommodates the sensor unit 10 and the optical unit 20 (and spring member 60), the holder 40 that holds the sensor unit 10 and the optical unit 20 is also accommodated in the housing 30. On the other hand, in a case where the vehicle body attachment member 100 temporarily holds the housing 30 to hold the body portion 3, vibration of the housing 30 may be transmitted to the vehicle body. Therefore, it is desirable that the vehicle body attachment member 100 holds the holder 40 in which the vibration is suppressed rather than holding the housing 30.

Therefore, in the present embodiment, a gap is formed between the upper housing 32 and the lower housing 33 on a side surface of the housing 30. The holder 40 includes the projection portion 41. The projection portion 41 is inserted into the gap of the housing 30 (gap between upper housing 32 and lower housing 33). The projection portion 41 of the holder 40 protrudes from the gap of the housing 30 to the outside of the housing 30. Accordingly, the vehicle body attachment member 100 can hold the holder 40 by gripping the projection portion 41 protruding to the outside of the housing 30. Therefore, in the present embodiment, transmission of vibration to the vehicle body can be reduced.

When a structure in which the projection portion 41 of the holder 40 is inserted into the gap (gap between upper housing 32 and lower housing 33) of the housing 30 is adopted, an interval (looseness) needs to be provided between the projection portion 41 and the housing 30. On the other hand, in a case where there is a gap between the projection portion 41 and the housing 30, dust or the like may enter the housing 30 from the outside.

Therefore, in the present embodiment, the measuring device 1 includes the gasket 35 that seals the gap between the housing 30 and the projection portion 41 of the holder 40. It is possible to prevent dust or the like from entering the housing 30 from the outside by the gasket 35 sealing the gap between the housing 30 and the projection portion 41 of the holder 40.

It is desirable that the gasket 35 is made of flexible rubber. It is possible to prevent the housing 30 and the holder 40 from being excessively firmly fixed to each other by interposing the gasket 35 between the housing 30 and the holder 40. Accordingly, transmission of vibration of the housing 30 to the holder 40 can be suppressed, and thus transmission of vibration to the vehicle body can be suppressed.

As described above, the stator (coil 71) of the drive unit 70 is fixed to the housing 30 (see FIG. 2). Therefore, the housing 30 is a member that vibrates more easily than the holder 40. Therefore, it is desirable that the vehicle body attachment member 100 holds the holder 40 rather than holding the housing 30. Therefore, the structure in which the vehicle body attachment member 100 holds the projection portion 41 of the holder 40 is a particularly desirable structure when the stator (coil 71) of the drive unit 70 is fixed to the housing 30.

### <Regarding Vehicle Body Attachment Member 100>

As illustrated in FIG. 15, the vehicle body attachment member 100 sandwiches the projection portion 41 of the holder 40 via the damper member 130. The vehicle body attachment member 100 includes the first attachment member 110 and the second attachment member 120. The projection portion 41 of the holder 40 is disposed between the first attachment member 110 and the second attachment member 120. The damper member 130 is disposed between the first attachment member 110 and the projection portion 41 and between the second attachment member 120 and the projection portion 41. The first attachment member 110 and the second attachment member 120 are fastened by screws (not illustrated), so that the damper member 130 is compressed in the upper-lower direction, and the projection portion 41 of the holder 40 is sandwiched between the first attachment member 110 and the second attachment member 120 via the damper member 130. The vehicle body attachment member 100 sandwiches the projection portion 41 of the holder 40 via the damper member 130 as in the present embodiment, so that it is possible to suppress transmission of vibration of the body portion 3 (particularly, vibration in upper-lower direction) to the vehicle body. The structure in which the vehicle body attachment member 100 sandwiches the projection portion 41 of the holder 40 via the damper member 130 is not limited to that using the first attachment member 110 and the second attachment member 120 as illustrated in FIG. 15, and may be another structure.

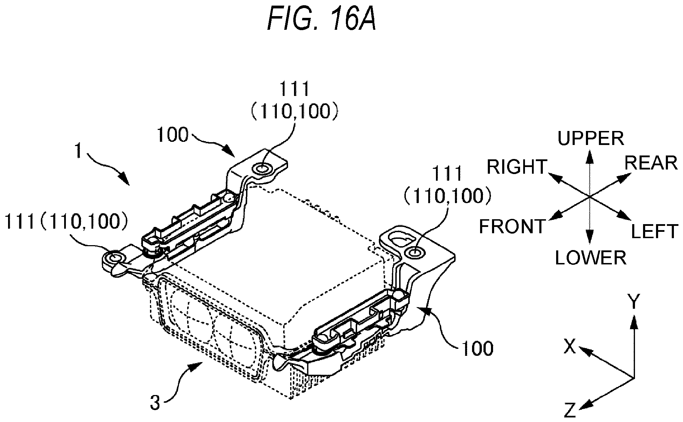

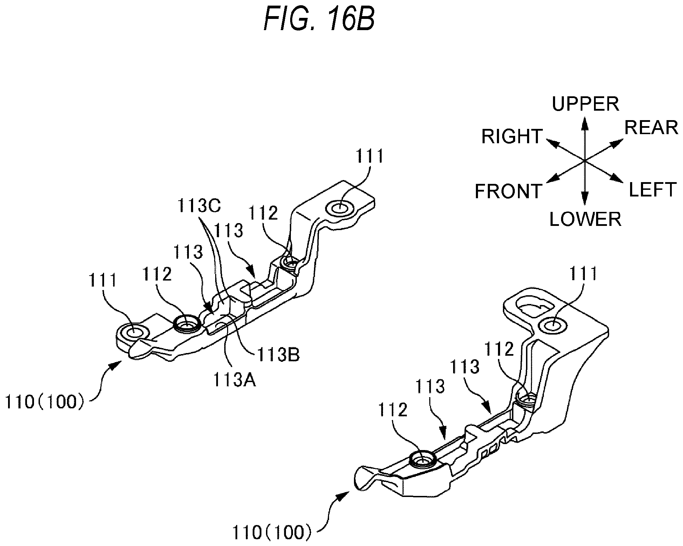

FIG. 16A illustrates the vehicle body attachment member 100. FIG. 16B is a perspective view of the first attachment member 110.

The first attachment member 110 includes a vehicle body attachment portion 111, a fixing portion 112, and an accommodating portion 113. The vehicle body attachment portion 111 is a portion (attachment hole) for attaching the vehicle body attachment member 100 to the vehicle body. The fixing portion 112 is a portion that fixes the second attachment member 120. The accommodating portion 113 is a portion that accommodates the damper member 130. The accommodating portion 113 is formed in a concave shape, and the damper member 130 is accommodated in a space inside the concave-shaped accommodating portion 113.

The accommodating portion 113 includes a bottom surface 113A and an inner wall surface 113B rising from the bottom surface 113A. The damper member 130 is accommodated in a space surrounded by the bottom surface 113A and the inner wall surface 113B. The bottom surface 113A is a surface perpendicular to the upper-lower direction (surface parallel to horizontal direction). The bottom surface 113A is a surface facing the projection portion 41 of the holder 40. In addition, the bottom surface 113A serves as a placement surface on which the damper member 130 is placed. The damper member 130 is sandwiched between the bottom surface 113A and a lower surface of the projection portion 41. The inner wall surface 113B is a surface parallel to the upper-lower direction. Here, the inner wall surface 113B includes a pair of facing surfaces (first surfaces) perpendicular to the front-rear direction and a pair of facing surfaces (second surfaces) perpendicular to the left-right direction.

As illustrated in FIG. 15, there is a gap S between the inner wall surface 113B of the first attachment member 110 and a side surface of the damper member 130 in the horizontal direction (direction perpendicular to upper-lower direction; front-rear direction and left-right direction). Accordingly, shear deformation of the damper member 130 can be allowed, and transmission of vibration of the body portion 3 (in particular, vibration in horizontal direction) to the vehicle body can be suppressed.

In a case where the projection portion 41 of the holder 40 is excessively displaced in the horizontal direction (front-rear direction and left-right direction) with respect to the vehicle body attachment member 100, shear deformation of the damper member 130 becomes large, and the damper member 130 may be damaged. Therefore, in the present embodiment, a part of the inner wall surface 113B of the first attachment member 110 is provided to the same height as the side surface of the projection portion 41 of the holder 40, thereby forming a contact portion 113C that comes into contact with the projection portion 41. The contact portion 113C of the first attachment member 110 comes into contact with the projection portion 41, so that the projection portion 41 of the holder 40 can be prevented from being largely displaced in the horizontal direction with respect to the vehicle body attachment member 100. That is, the contact portion 113C of the first attachment member 110 functions as a stopper that limits a maximum displacement amount of the holder 40 in the horizontal direction. The contact portion 113C is not limited to that illustrated in FIG. 15, and may be any configuration as long as it can come into contact with the projection portion 41. For example, the second attachment member 120 may include a contact portion that can come into contact with the projection portion 41. In addition, the vehicle body attachment member 100 may not include a contact portion that can come into contact with the projection portion 41.

### <Regarding Lens Housing 23>

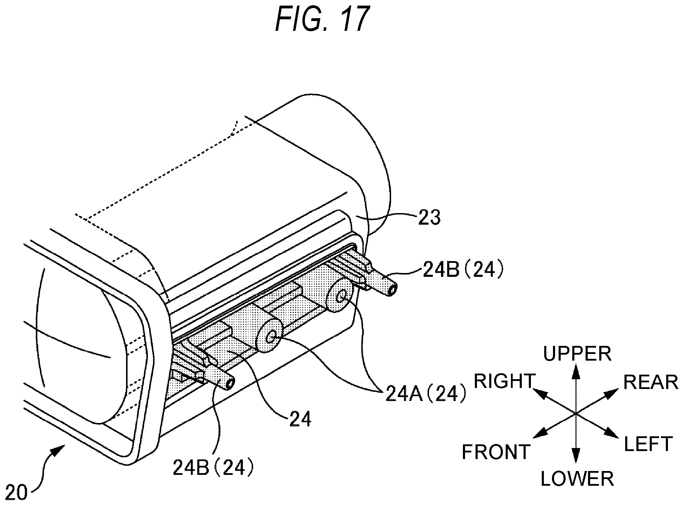

FIG. 17 illustrates the insert component 24 of the lens housing 23. A part hatched in FIG. 17 is the insert component 24.

As described above, the fixing portion 24A is provided on the side surface of the lens housing 23 of the optical unit 20, and the spring member 60 is screwed to the fixing portion 24A. On the other hand, since the spring member 60 includes the vibration portion 62, a screw for fastening the spring member 60 to the optical unit 20 may be loosened. Therefore, a screw for fixing the optical unit 20 and the spring member 60 needs to be fastened with high torque.

On the other hand, there is also a demand that the lens housing 23 is made of lightweight resin or aluminum in order to reduce the weight of the body portion 3 of the measuring device 1. However, in a case where the fixing portion 24A (screw hole) of the lens housing 23 is made of resin or aluminum, the strength of the resin or aluminum is relatively weak, and therefore, the screw cannot be fastened to the fixing portion 24A (screw hole) with high torque (or in a case where the screw is fastened to the fixing portion 24A (screw hole) with high torque, the fixing portion 24A may be damaged).

Therefore, in the present embodiment, the lens housing 23 is formed by insert molding. Here, a body (portion not hatched in FIG. 17) of the lens housing 23 is made of resin. The body made of resin and the insert component 24 made of metal are integrated by insert molding. A material of the body of the lens housing 23 is not limited to resin, and may be another material (for example, aluminum).

The insert component 24 is made of metal having higher strength than resin or aluminum, and is made of stainless steel (SUS) here. However, the insert component 24 is not limited to stainless steel (SUS), and may have a higher strength than the material constituting the body of the lens housing 23.

The insert component 24A is formed with the fixing portion 24A. In the present embodiment, since the fixing portion 24A (screw hole) is formed in the insert component 24, the spring member 60 may be screwed to the fixing portion 24A with high torque.

The optical unit 20 includes a pair of insert components 24. The pair of insert components 24 are respectively disposed on left and right side surfaces of the optical unit 20 (lens housing 23). A lens group of the optical unit 20 is disposed between the pair of insert components 24.

The pair of insert components 24 have the same shape. The left and right insert components 24 are commonality, so that the manufacturing cost can be reduced. In order to make the insert components 24 disposed on the left and right sides of the optical unit 20 have the same shape, the insert components 24 have vertically symmetrical shapes. The pair of insert components 24 are disposed at the same height as the optical axis of the optical unit 20 so as to face each other sandwiching the optical axis of the optical unit 20 (see also FIG. 15). Since the pair of insert components 24 are disposed at the same height as the optical axis of the optical unit 20, the stationary portion 61 of the spring member 60 fixed to the insert component 24 is easily disposed in accordance with the center of gravity of the optical unit 20. In addition, since the pair of insert components 24 are disposed at the same height as the optical axis of the optical unit 20, the holder 40 easily holds the vicinity of the center of gravity of the optical unit 20 via the spring member 60.

The insert component 24 includes an alignment pin 24B. As described above, the alignment pin 24B is a portion for aligning the spring member 60 and the holder 40. By providing the alignment pin 24B at the insert component 24, damage to the alignment pin 24B can be suppressed, and highly accurate alignment becomes possible. Further, by providing the fixing portion 24A and the alignment pin 24B at the same insert component 24, the spring member 60 can be fixed to the optical unit 20 in a state where the optical unit 20 and the spring member 60 are aligned with high accuracy. Further, since the alignment pin 24B is inserted into both the alignment hole 61C of the spring member 60 and the alignment hole 46 of the holder 40, the spring member 60 and the holder 40 can be aligned with the optical unit 20. Accordingly, the holder 40 can be fixed to the spring member 60 in a state where the spring member 60 and the holder 40 are aligned.

The insert component 24 includes two alignment pins 24B. The two alignment pins 24B are disposed at an interval in the front-rear direction. The fixing portion 24A (screw hole) is formed between the two alignment pins 24B. That is, the two alignment pins 24B are disposed on an outer side in the front-rear direction with respect to the fixing portion 24A. Accordingly, the interval between the two alignment pins 24B can be widened, and the alignment accuracy can be improved.

Similarly, two alignment holes 61C are formed in the stationary portion 61 of the spring member 60 (see FIG. 13). The two alignment holes 61C are disposed at an interval in the front-rear direction. The first hole 61A and the second hole 61B are formed in the stationary portion 61 between the two alignment holes 61C. That is, the two alignment holes 61C are disposed on the outer side in the front-rear direction with respect to the first hole 61A and the second hole 61B. Accordingly, the interval between the two alignment holes 61C can be widened, and the alignment accuracy can be improved.

The fixing portion 24A and the alignment pin 24B may not necessarily be formed at the insert component 24.

### <Regarding Screw>

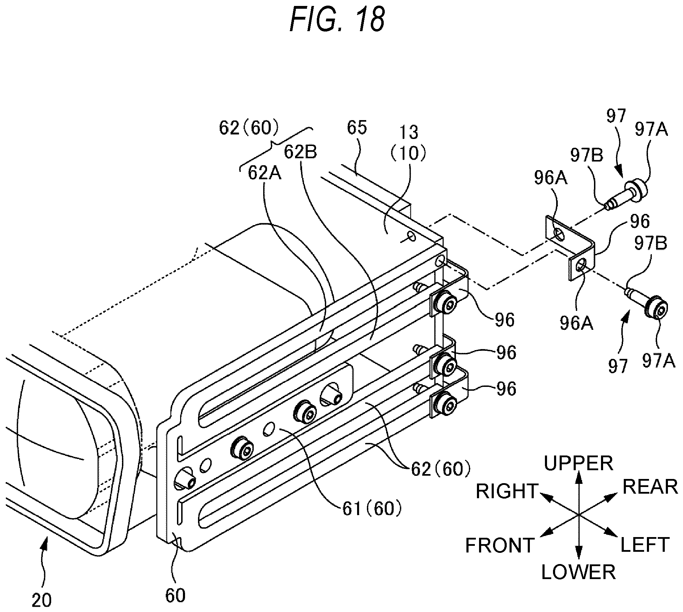

FIG. 18 illustrates an example of the end portion of the vibration portion 62 of the spring member 60.

As illustrated in FIG. 18, the vibration portion 62 (specifically, rear end of first bending portion 62A) of the spring member 60 is coupled to the sensor unit 10 via a hinge member 96. Similarly, the vibration portion 62 of the spring member 60 (specifically, rear end of second bending portion 62B) is coupled to the vibration member 65 via the hinge member 96.

The hinge member 96 is a member that couples the spring member 60 and the sensor unit 10 (or vibration member 65). The hinge member 96 is an L-shaped member. Here, the hinge member 96 is formed of a bent metal plate. In order to couple the vibration portion 62 parallel to the front-rear direction and the sensor unit 10 (or vibration member 65) perpendicular to the front-rear direction, the spring member 60 and the sensor unit 10 (or vibration member 65) are coupled via the hinge member 96.

An attachment screw 97 is a screw for attaching the hinge member 96. One end of the hinge member 96 is screwed to the vibration portion 62 of the spring member 60 by the attachment screw 97. The other end of the hinge member 96 is screwed to the sensor unit 10 (or vibration member 65) by another attachment screw 97.

Since the distal end of the vibration portion 62 (specifically, first bending portion 62A and second bending portion 62B) of the spring member 60 is a relatively thin portion, the attachment screw 97 needs to have a relatively small diameter in order to fix the hinge member 96 to the distal end of the vibration portion 62. Since the hinge member 96 is disposed at a position where other components are concentrated, the attachment screw 97 needs to have a small size. On the other hand, since the hinge member 96 is attached to a vibrating member, the attachment screw 97 needs to be fastened with a predetermined relatively high torque. That is, the attachment screw 97 needs to be fastened with a predetermined relatively high torque although it has a small diameter and a small size. Therefore, in the present embodiment, the attachment screw 97 is automatically fastened using a screw tightening machine, instead of a worker fastening the attachment screw 97.

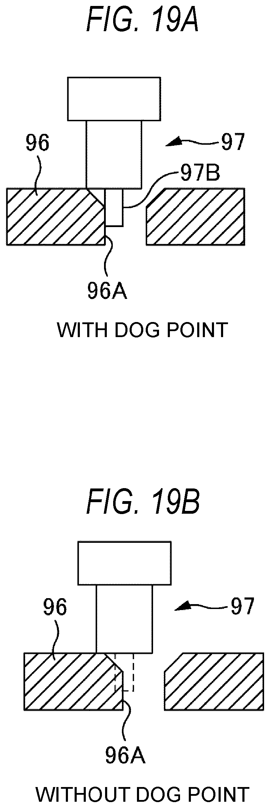

FIGS. 19A and 19B illustrate a state where the attachment screw 97 is attached.

The attachment screw 97 includes a dog point 97B. That is, the attachment screw 97 is implemented by a dog point screw. The dog point 97B is a cylindrical projection having a diameter smaller than that of a screw portion. The dog point 97B is provided at an end portion (distal end) opposite to a head portion 97A of the attachment screw 97.

A through hole 96A through which the attachment screw 97 is inserted is formed in the end portion of the hinge member 96. An opening portion of the through hole 96A is chamfered. Here, the opening portion of the through hole 96A is C-chamfered.

As illustrated in FIGS. 19A and 19B, the attachment screw 97 includes the dog point 97B, so that the dog point 97B can be guided to the opening (C surface) of the through hole 96A. In this manner, in the present embodiment, the attachment screw 97 is automatically fastened using a screw tightening machine. The vibration portion 62 of the spring member 60 and the sensor unit 10 (or vibration member 65) may be fastened by the attachment screw 97 without the hinge member 96. In this case, the attachment screw 97 includes the dog point 97B, so that the attachment screw 97 can also be automatically fastened using the screw tightening machine.

As illustrated in FIG. 18, it is desirable that the head portion 97A of the attachment screw 97 is smaller than the width of the hinge member 96. That is, it is desirable that the diameter of the head portion 97A of the attachment screw 97 is smaller than a dimension in the upper-lower direction of the hinge member 96. Accordingly, the head portion 97A of the attachment screw 97 can be prevented from protruding from the hinge member 96. Since the hinge member 96 is disposed at a position where other components are concentrated, it is effective that the head portion 97A of the attachment screw 97 does not protrude from the hinge member 96.

### <Summary>

As described above, the measuring device 1 includes the sensor unit 10, the optical unit 20, the spring member 60, and the holder 40. The sensor unit 10 includes the light emitting element 11 configured to emit light and the light receiving element 12 configured to receive reflected light. The optical unit 20 is configured to irradiate an object with the light emitted from the light emitting element 11 and configured to cause the light receiving element 12 to receive the reflected light. The spring member 60 includes the stationary portion 61 and the vibration portion 62, the stationary portion 61 is attached to the optical unit 20, and the sensor unit 10 is attached to the vibration portion 62, so that the sensor unit 10 is movably held with respect to the optical unit 20. The holder 40 is attached to the stationary portion 61 of the spring member 60, and holds the sensor unit 10 and the optical unit 20 in a relatively movable manner. Since the stationary portion 61 of the spring member 60 is a portion that is hard to vibrate, the vibration of the holder 40 can be suppressed by attaching the holder 40 to the stationary portion 61 of the spring member 60.

In addition, the measuring device 1 includes the vehicle body attachment member 100 and the housing 30. Since the housing 30 accommodates the sensor unit 10 and the optical unit 20, the holder 40 that holds the sensor unit 10 and the optical unit 20 is also accommodated in the housing 30. However, in a case where the vehicle body attachment member 100 temporarily holds the housing 30, vibration of the housing 30 may be transmitted to the vehicle body. Therefore, in the present embodiment, the projection portion 41 is provided on the holder 40, and the vehicle body attachment member 100 holds the projection portion 41 protruding from the gap of the housing 30 to the outside of the housing 30. Accordingly, transmission of vibration to the vehicle body can be suppressed.

In addition, the measuring device 1 includes the gasket 35 that seals the gap between the housing 30 and the projection portion 41 of the holder 40. By interposing the gasket 35 between the housing 30 and the holder 40, transmission of vibration of the housing 30 to the holder 40 can be reduced.

The measuring device 1 includes the drive unit 70 configured to move the sensor unit 10 relative to the optical unit 20, and the stator of the drive unit 70 is fixed to the housing 30. In such a structure, since the housing 30 is a member that vibrates more easily than the holder 40, a structure in which the vehicle body attachment member 100 holds the projection portion 41 of the holder 40 is particularly advantageous.

The vehicle body attachment member 100 sandwiches the projection portion 41 via the damper member 130. Accordingly, it is possible to suppress transmission of vibration of the body portion 3 (particularly, vibration in upper-lower direction) to the vehicle body.

In addition, the gap S is provided between the vehicle body attachment member 100 and the damper member 130 in a horizontal direction (direction perpendicular to direction in which vehicle body attachment member 100 sandwiches projection portion 41) (see FIG. 15). Accordingly, it is possible to suppress transmission of vibration of the body portion 3 (particularly, vibration in horizontal direction) to the vehicle body.

In addition, the vehicle body attachment member 100 includes the contact portion 113C that may come into contact with the projection portion 41. Accordingly, the maximum displacement amount of the holder 40 can be limited.

The optical unit 20 includes the insert component 24 formed by insert molding, and the stationary portion 61 of the spring member 60 is screwed to the insert component 24. Accordingly, the optical unit 20 and the spring member 60 can be firmly fixed.

The optical unit 20 includes a pair of insert components 24 having the same shape, and the pair of insert components 24 are disposed to face each other at the same height as an optical axis of the optical unit 20 so as to sandwich the optical axis of the optical unit 20. By making the insert component 24 commonality, the manufacturing cost can be reduced.

The insert component 24 includes the alignment pin 24B, and the alignment hole 61C is formed in the stationary portion 61 of the spring member 60. By providing the alignment pin 24B at the insert component 24, damage to the alignment pin 24B can be suppressed, and highly accurate alignment of the optical unit 20 and the spring member 60 becomes possible.

The first hole 61A through which the spring member 60 is screwed to the optical unit 20 and the second hole 61B through which the holder 40 is attached to the spring member 60 are formed in the stationary portion 61 of the spring member 60. The first hole 61A and the second hole 61B are formed inside the two alignment holes 61C. Accordingly, the interval between the two alignment holes 61C can be widened, and the alignment accuracy can be improved.

The attachment screw 97 for attaching the vibration portion 62 of the spring member 60 and the sensor unit 10 includes the dog point 97B. Accordingly, the vibration portion 62 of the spring member 60 and the sensor unit 10 are easily attached using the screw tightening machine.

The vibration portion 62 of the spring member 60 and the sensor unit 10 are fixed via the hinge member 96, and the head portion 97A of the attachment screw 97 is smaller than a width of the hinge member 96. Accordingly, the head portion 97A of the attachment screw 97 can be prevented from protruding from the hinge member 96.

### <Regarding Vehicle Body Attachment Member>

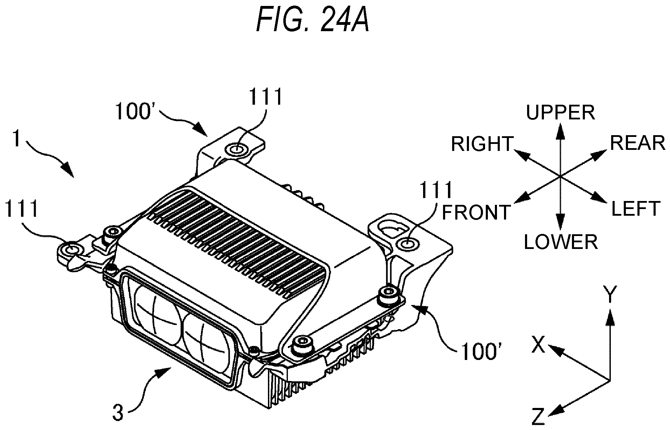

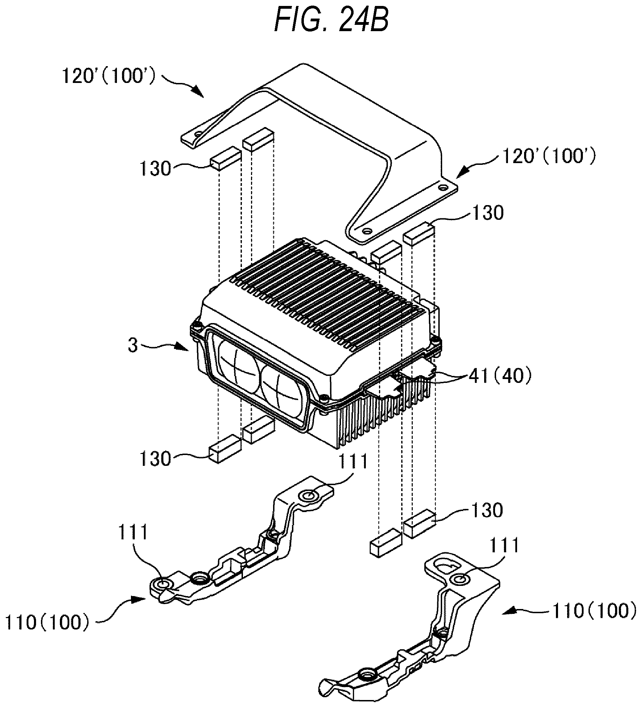

FIGS. 24A and 24B illustrate a vehicle body attachment member 100' according to a comparative example.

In the comparative example, the vehicle body attachment member 100' also holds both left and right sides of the body portion 3 (specifically, projection portion 41 of holder 40 protruding from left and right side surfaces of body portion 3). The vehicle body attachment member 100' according to the comparative example includes a coupling member 120' instead of the pair of second attachment members 120. In the comparative example, the first attachment member 110 and the coupling member 120' are fastened with a screw, so that the body portion 3 (specifically, projection portion 41 of holder 40) is sandwiched between the first attachment member 110 and the coupling member 120'.

In the comparative example, a pair of first attachment members 110 are coupled by the coupling member 120'. When the pair of first attachment members 110 is fixed to the coupling member 120', the pair of first attachment members 110 is integrally combined via the coupling member 120'. That is, in the comparative example, the vehicle body attachment member 100' holding the body portion 3 has a structure in which the left and right are not separated. The coupling member 120' is shaped to straddle the body portion 3 in the left-right direction, and thus is a relatively large member. In addition, since the coupling member 120' needs to straddle the body portion 3 in the left-right direction, a dimension of the measuring device 1 in the upper-lower direction increases.

The vehicle body attachment member 100' includes the vehicle body attachment portion 111 on the left and right sides, and the vehicle body attachment portions 111 (attachment hole) are attached to a predetermined attachment position (not illustrated) of the vehicle body, so that the measuring device 1 is attached to the vehicle body. Therefore, the left and right vehicle body attachment portions 111 need to be disposed at positions and intervals suitable for predetermined attachment positions of the vehicle body. When the vehicle body attachment members 100' that holds the left and right sides of the body portion 3 are integrally combined as in the comparative example, it is necessary to manufacture the coupling member 120' with high accuracy in order to set the left and right vehicle body attachment portions 111 at predetermined positions and intervals. However, since the coupling member 120' is a relatively large member so as to straddle the body portion 3 in the left-right direction, it is difficult to manufacture the coupling member 120' with high accuracy (or the manufacturing cost increases). In addition, when the coupling member 120' cannot be manufactured with high accuracy, it is difficult to set the left and right vehicle body attachment portions 111 at predetermined positions and intervals, and it is difficult to form the vehicle body attachment portions 111 (attachment hole) at predetermined attachment positions (not illustrated) of the vehicle body.

As illustrated in FIG. 16, the measuring device 1 according to the present embodiment includes a pair of vehicle body attachment members 100. The pair of vehicle body attachment members 100 are not coupled to each other and are separated from each other. The pair of vehicle body attachment members 100 according to the present embodiment independently hold both left and right sides of the body portion 3. Therefore, in the present embodiment, since there is no member (for example, coupling member 120' according to comparative example) that straddles the body portion 3 in the left-right direction, it is possible to reduce the size of the vehicle body attachment member 100, and it is possible to reduce the size of the measuring device 1. In addition, since the pair of vehicle body attachment members 100 are separated from each other, the left and right vehicle body attachment portions 111 may be adjusted to have a predetermined positional relation. Adjustment on the positional relation between the left and right vehicle body attachment portions 111 will be described later.

### <Regarding Adjustment on Position of Pair of Vehicle Body Attachment Members 100>

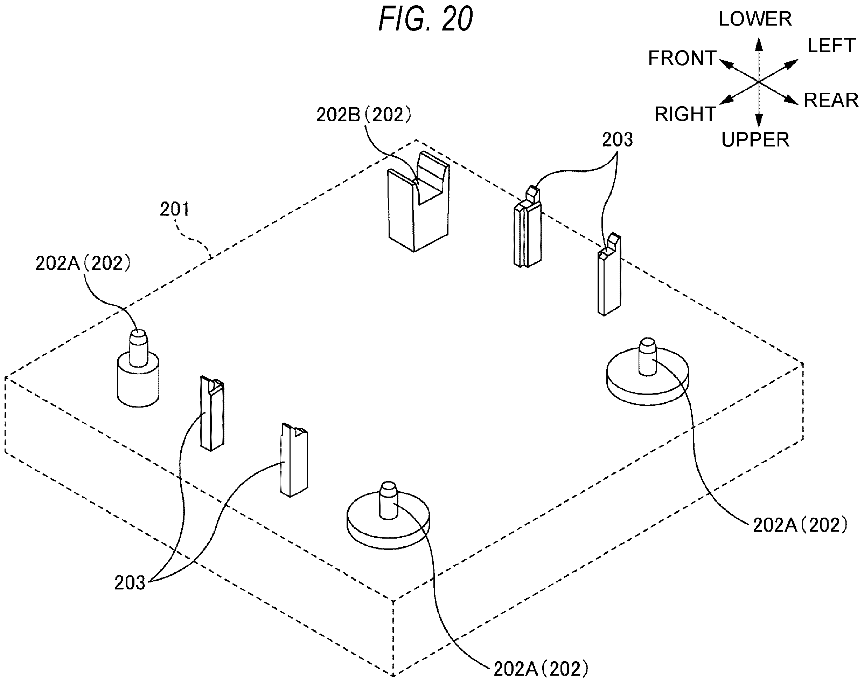

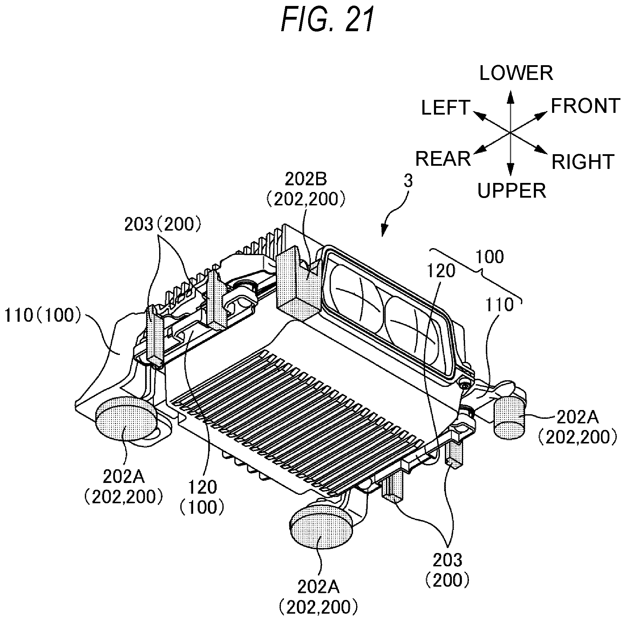

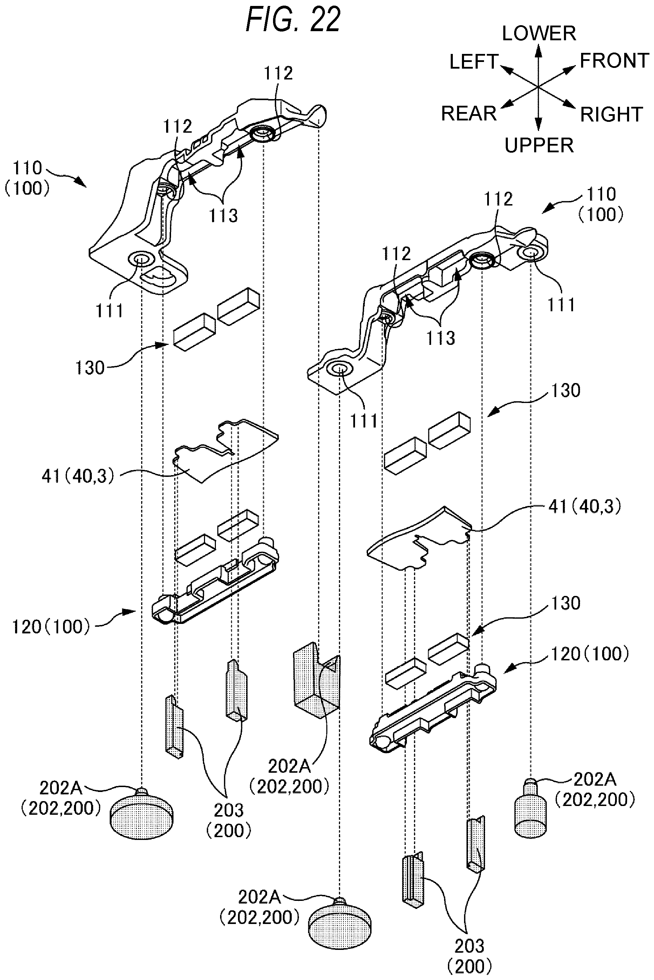

FIG. 20 illustrates a jig 200. FIG. 21 illustrates a state where the vehicle body attachment members 100 are set in the jig 200. FIG. 22 illustrates a positional relation among members set in the jig 200.

In FIG. 20, a body 201 of the jig 200 is indicated by a dotted line. Eight portions (positioning portions 202 and contact portions 203) of the jig 200 in FIG. 20 are integrally implemented by the body 201 (see dotted line), and are disposed in a predetermined positional relation. In FIGS. 21 and 22, portions (positioning portions 202 and contact portions 203) constituting the jig 200 are hatched, and the body 201 of the jig 200 is not illustrated (each portion is illustrated in a state where the body 201 is transparent). FIG. 22 does not illustrate the body portion 3 other than the projection portion 41 in order to illustrate the positional relation between the jig 200 and the vehicle body attachment member 100. In FIGS. 20 to 22, directions are illustrated in accordance with the body portion 3 to be set. The body portion 3 is set in the jig 200 upside down.

The jig 200 is a member for adjusting positions of the pair of vehicle body attachment members 100. The jig 200 is used to cause the pair of vehicle body attachment members 100 to hold the body portion 3 at the time of manufacturing the measuring device 1.

The jig 200 includes a plurality of positioning portions 202. The positioning portion 202 is a portion that performs positioning of the first attachment member 110. The plurality of positioning portions 202 are disposed in a predetermined positional relation on the body 201 of the jig 200 so as to match predetermined attachment positions (not illustrated) of the vehicle body.

The positioning portions 202 are implemented by a plurality of (three in the present embodiment) positioning pins 202A and a positioning groove 202B. As described above, the first attachment member 110 has an attachment hole (vehicle body attachment portion 111) used for attachment to the vehicle body. The positioning pin 202A is a portion to be inserted into the attachment hole (vehicle body attachment portion 111) of the first attachment member 110. The positioning pin 202A is a pin extending in the upper-lower direction. By inserting the positioning pin 202A into the vehicle body attachment portion 111 of the first attachment member 110, the first attachment member 110 can be aligned with the jig 200 (in direction perpendicular to upper-lower direction). By inserting the positioning pins 202A into the respective attachment holes (vehicle body attachment portions 111) of the pair of vehicle body attachment members 100, the positional relation between the pair of vehicle body attachment members 100 can be adjusted, and the left and right vehicle body attachment portions 111 of the vehicle body attachment member 100 can be set at predetermined positions and intervals. The positioning groove 202B is a groove-shaped portion for sandwiching the end portion of the first attachment member 110 in the horizontal direction (here, left-right direction). The positioning groove 202B is a portion for suppressing rotation of the first attachment member 110 with respect to the jig 200. In this manner, the positioning portion 202 is not limited to a pin shape.

When the measuring device 1 is assembled using the jig 200, first, the body portion 3, the pair of vehicle body attachment members 100, and the jig 200 are prepared. Then, after the second attachment member 120 and the body portion 3 (and damper member 130) are set in order in the jig 200, the positioning pins 202A of the jig 200 are inserted into the attachment holes (vehicle body attachment portion 111) of the first attachment member 110 of the vehicle body attachment member 100, thereby adjusting the positional relation between the pair of vehicle body attachment members 100. Then, the first attachment member 110 and the second attachment member 120 are fastened with screws (not illustrated) in a state where the positioning pins 202A of the jig 200 are inserted into the attachment hole (vehicle body attachment portion 111) of the first attachment member 110 (that is, in a state where the positional relation between the pair of vehicle body attachment members 100 is adjusted), thereby sandwiching the projection portion 41 of the body portion 3 between the first attachment member 110 and the second attachment member 120. Accordingly, both left and right sides of the body portion 3 can be held by the pair of vehicle body attachment members 100.

It is desirable that the body portion 3 is aligned with the vehicle body attachment member 100 when the projection portion 41 of the body portion 3 is sandwiched between the first attachment member 110 and the second attachment member 120. Therefore, the jig 200 according to the present embodiment includes the contact portion 203 configured to come into contact with the body portion 3 (specifically, projection portion 41).

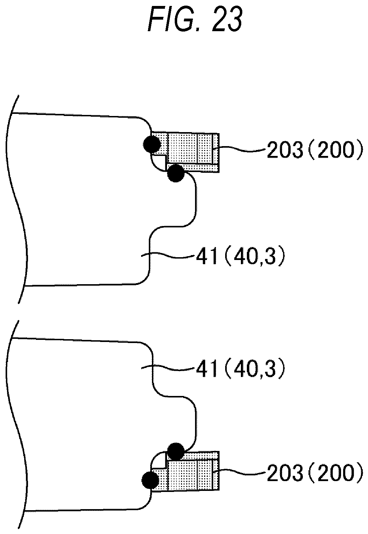

FIG. 23 illustrates a state where the contact portion 203 and the projection portion 41 are in contact with each other. A circle mark in FIG. 23 illustrates a portion where the contact portion 203 and the projection portion 41 are in contact with each other.

When the body portion 3 is set in the jig 200, the projection portion 41 of the body portion 3 is brought into contact with the contact portion 203 of the jig 200. By bringing the contact portion 203 and the projection portion 41 into contact with each other, the projection portion 41 is aligned with the jig 200 in the horizontal direction (direction perpendicular to upper-lower direction), and the body portion 3 is aligned with the jig 200. By inserting the positioning pin 202A into the attachment hole (vehicle body attachment portion 111) of the vehicle body attachment member 100, the vehicle body attachment member 100 is aligned with the jig 200, and therefore, by bringing the contact portion 203 into contact with the projection portion 41, the body portion 3 can be aligned with the vehicle body attachment member 100 via the jig 200.

When the measuring device 1 is assembled using the jig 200, the projection portion 41 of the body portion 3 is sandwiched between the first attachment member 110 and the second attachment member 120 by fastening the first attachment member 110 and the second attachment member 120 with screws (not illustrated) in a state where the positioning pin 202A of the jig 200 is inserted into the attachment hole (vehicle body attachment portion 111) of the first attachment member 110 (that is, in a state where the vehicle body attachment member 100 is aligned with the jig 200) and in a state where the contact portion 203 of the jig 200 is in contact with the projection portion 41 (that is, in a state where the body portion 3 is aligned with the jig 200). Accordingly, the measuring device 1 can be assembled (the measuring device 1 can be manufactured) in a state where the body portion 3 is aligned with the vehicle body attachment member 100.

When the second attachment member 120, the body portion 3, and the first attachment member 110 are set in order in the jig 200, it is desirable to bond the damper member 130 to each of the first attachment member 110 and the second attachment member 120 in advance. Accordingly, the projection portion 41 of the body portion 3 can be sandwiched between the first attachment member 110 and the second attachment member 120 in a state where the gap S illustrated in FIG. 15 is set to a predetermined interval. By bonding the damper member 130 to the first attachment member 110 and the second attachment member 120 in advance, it is easy to sandwich the projection portion 41 between the first attachment member 110 and the second attachment member 120 via the damper member 130. However, the damper member 130 may be bonded to neither the first attachment member 110 nor the second attachment member 120.

It is desirable that a portion where the projection portion 41 comes into contact with the contact portion 203 of the jig 200 is common to a portion where the projection portion 41 comes into contact with the contact portion 113C of the first attachment member 110. Accordingly, the shape of the projection portion 41 can be simplified as compared with a case where a portion where the projection portion 41 comes into contact with the contact portion 203 of the jig 200 and a portion where the projection portion 41 comes into contact with the contact portion 113C of the first attachment member 110 are separate.

### <Summary>

As described above, the measuring device 1 includes the body portion 3 and the pair of vehicle body attachment members 100. The body portion irradiates an object with light and receives reflected light. The vehicle body attachment member 100 is a member that holds both left and right sides (both sides in width direction) of the body portion 3 in order to attach the body portion 3 to the vehicle body. Here, in a case where the vehicle body attachment member 100' is temporarily integrally implemented so as to straddle the left and right of the body portion 3 as in the comparative example (see FIG. 24A), the measuring device 1 may be increased in size. In contrast, in the present embodiment, the pair of vehicle body attachment members 100 independently hold both left and right sides (both sides in width direction of body portion 3) of the body portion 3. The pair of vehicle body attachment members 100 are separated from each other in the left-right direction, so that the size of the vehicle body attachment members 100 can be reduced and the size of the measuring device 1 can be reduced as compared with the comparative example.

The body portion 3 includes the sensor unit 10, the optical unit 20, the holder 40 that holds the sensor unit 10 and the optical unit 20 in a relatively movable manner, and the housing 30. Since the housing 30 accommodates the sensor unit 10 and the optical unit 20, the holder 40 that holds the sensor unit 10 and the optical unit 20 is also accommodated in the housing 30. However, in a case where the vehicle body attachment member 100 temporarily holds the housing 30, vibration of the housing 30 may be transmitted to the vehicle body. Therefore, in the present embodiment, the projection portion 41 is provided on the holder 40, and the vehicle body attachment member 100 holds the projection portion 41 protruding from the gap of the housing 30 to the outside of the housing 30. Accordingly, transmission of vibration to the vehicle body can be suppressed.

The vehicle body attachment member 100 sandwiches the projection portion 41 via the damper member 130. Accordingly, it is possible to suppress transmission of vibration of the body portion 3 (particularly, vibration in upper-lower direction) to the vehicle body.

In addition, the gap S is provided between the vehicle body attachment member 100 and the damper member 130 in a horizontal direction (direction perpendicular to direction in which vehicle body attachment member 100 sandwiches projection portion 41) (see FIG. 15). Accordingly, it is possible to suppress transmission of vibration of the body portion 3 (particularly, vibration in horizontal direction) to the vehicle body.

In addition, the vehicle body attachment member 100 includes the contact portion 113C that may come into contact with the projection portion 41. Accordingly, the maximum displacement amount of the holder 40 can be limited.

In the above assembly method (manufacturing method) of the measuring device, a step of preparing the body portion 3 and the pair of vehicle body attachment members 100, a step of adjusting the positional relation between the pair of vehicle body attachment members 100, and a step of holding both left and right sides (both sides in width direction) of the body portion 3 by the pair of vehicle body attachment members 100 in a state where the positional relation between the pair of vehicle body attachment members 100 is adjusted are performed. According to such a manufacturing method, the body portion 3 can be held by using the pair of vehicle body attachment members 100 separated to the left and right. Therefore, the size of the vehicle body attachment members 100 can be reduced, and the size of the measuring device 1 can be reduced.

In the above assembly method (manufacturing method) of the measuring device 1, the positional relation between the pair of vehicle body attachment members 100 is adjusted using the jig 200. In this manner, the use of the jig 200 facilitates the step of adjusting the positional relation between the pair of vehicle body attachment members 100. In addition, the use of the jig 200 facilitates the step of holding the left and right sides (both sides in width direction) of the body portion 3 by the pair of vehicle body attachment members 100 in a state where the positional relation between the pair of vehicle body attachment members 100 is adjusted. The positional relation between the pair of vehicle body attachment members 100 may be adjusted by using a jig different from the above-described jig 200. In addition, the positional relation between the pair of vehicle body attachment members 100 may be adjusted without using a jig.

In addition, the jig 200 includes the positioning pin 202A, and in the assembly method (manufacturing method) of the measuring device 1, the positioning pin 202A is inserted into the attachment hole (vehicle body attachment portion 111) of the vehicle body attachment member 100, thereby adjusting the positional relation between the pair of vehicle body attachment members 100. Accordingly, since the attachment holes (vehicle body attachment portions 111) of the pair of vehicle body attachment members 100 can be adjusted to have a predetermined positional relation, the vehicle body attachment portions 111 of the measuring device 1 after completion can be disposed at positions and intervals suitable for a predetermined attachment position of the vehicle body.

In addition, the jig 200 includes the contact portion 203, and in the assembly method (manufacturing method) of the measuring device 1, the body portion 3 is brought into contact with the contact portion 203 of the jig 200, thereby aligning the body portion 3 with the vehicle body attachment member 100. Accordingly, the measuring device 1 can be assembled (the measuring device 1 can be manufactured) in a state where the body portion 3 is aligned with the vehicle body attachment member 100.

Although embodiments of the present disclosure have been described in detail above, the present disclosure is not limited to the above embodiments, and includes various modifications. The configuration of the above embodiment has been described in detail for easy understanding of the present disclosure, and the present disclosure is not necessarily limited to that including all the configurations described. It is possible to add, delete, or replace a part of the configuration of the above embodiment with another configuration.

The present application appropriately refers to contents disclosed in Japanese Patent Application filed on Jan. 18, 2022 (JP2022-005809A), Japanese Patent Application filed on Jan. 18, 2022 (JP2022-005810A), and Japanese Patent Application filed on Jan. 18, 2022 (JP2022 -005811A).

## Claims

1. A measuring device comprising:
a sensor unit including a light emitting element configured to emit light and a light receiving element configured to receive reflected light;
an optical unit configured to irradiate an object with the light emitted from the light emitting element and configured to cause the light receiving element to receive the reflected light;
a holder configured to hold the sensor unit and the optical unit in a relatively movable manner;
a substrate fixed to the holder; and
a support member that is deformable and configured to support an end portion of the substrate from the holder.

2. The measuring device according to claim 1,
wherein the substrate is fixed to the holder at three corners among four corners of the substrate, and
the substrate is supported from the holder by the support member at a corner of the substrate that is not fixed to the holder.

3. The measuring device according to claim 1 or 2,
wherein the support member includes:
a first fixing portion configured to fix the support member to the holder;
a second fixing portion configured to fix the support member to the substrate; and
a coupling portion that is deformable while coupling the first fixing portion and the second fixing portion.

4. The measuring device according to any of claims 1 to 3,
wherein the support member includes an alignment pin, and
the substrate includes an alignment portion configured to align the substrate with the alignment pin.

5. The measuring device according to claim 4,
wherein the alignment portion is a concave portion at a peripheral edge of the substrate.

6. The measuring device according to any of claims 1 to 5, further comprising:
a housing configured to accommodate the sensor unit, the optical unit, and the substrate while exposing an incident and emission surface of light of the optical unit; and
an electromagnetic shield member disposed between the substrate and the optical unit.

7. The measuring device according to any of claims 1 to 6, further comprising:
a housing; and
a heat transfer sheet sandwiched between the substrate and the housing.

8. The measuring device according to claim 7,
wherein the substrate includes a plurality of chips having different heights,
the housing includes a plurality of convex portions facing the chips and protruding toward the chips,
a projection amount of each of the convex portions is set to be larger as the facing chip is lower, and
the heat transfer sheet is compressed in a thickness direction between the chips and the convex portions.

9. The measuring device according to claim 7 or 8,
wherein the housing includes a heat radiation fin on an outer surface of the housing.

10. A measuring device comprising:
a sensor unit including a light emitting element configured to emit light, and a light receiving element configured to receive reflected light;
an optical unit configured to irradiate an object with the light emitted from the light emitting element and configured to cause the light receiving element to receive the reflected light;
a spring member including a stationary portion and a vibration portion, the spring member being configured to hold the sensor unit in a movable manner with respect to the optical unit by attaching the stationary portion to the optical unit and attaching the sensor unit to the vibration portion; and
a holder attached to the stationary portion of the spring member, and configured to hold the sensor unit and the optical unit in a relatively movable manner.

11. The measuring device according to claim 10, further comprising:
a vehicle body attachment member for attaching the measuring device to a vehicle body; and
a housing configured to accommodate the sensor unit, the optical unit, and the spring member,
wherein the holder includes a projection portion protruding from a gap of the housing to outside of the housing, and
the vehicle body attachment member holds the projection portion.

12. The measuring device according to claim 11, further comprising:
a gasket configured to seal the gap between the housing and the projection portion of the holder.

13. The measuring device according to claim 11 or 12, further comprising:
a drive unit configured to move the sensor unit relative to the optical unit,
wherein a stator of the drive unit is fixed to the housing.

14. The measuring device according to any of claims 11 to 13,
wherein the vehicle body attachment member sandwiches the projection portion via a damper member.

15. The measuring device according to claim 14,
wherein, between the vehicle body attachment member and the damper member, a gap is provided in a direction perpendicular to a direction in which the vehicle body attachment member sandwiches the projection portion.

16. The measuring device according to claim 15,
wherein the vehicle body attachment member includes a contact portion configured to come into contact with the projection portion.

17. The measuring device according to any of claims 10 to 16,
wherein the optical unit includes an insert component formed by insert molding, and
the stationary portion of the spring member is screwed to the insert component.

18. The measuring device according to claim 17,
wherein the optical unit includes a pair of the insert components having the same shape, and
the pair of insert components are disposed to face each other at the same height as an optical axis of the optical unit so as to sandwich the optical axis of the optical unit.

19. The measuring device according to claim 17 or 18,
wherein the insert component includes an alignment pin, and
the stationary portion of the spring member is formed with an alignment hole to be aligned with the alignment pin.

20. The measuring device according to claim 19,
wherein the stationary portion is formed with a first hole through which the spring member is screwed to the optical unit and a second hole through which the holder is attached to the spring member, and
the first hole and the second hole are formed between the two alignment holes.

21. The measuring device according to any of claims 10 to 20,
wherein a screw for attaching the vibration portion of the spring member and the sensor unit includes a dog point.

22. The measuring device according to claim 21,
wherein the vibration portion of the spring member and the sensor unit are fixed via a hinge member, and
a head portion of the screw is smaller than a width of the hinge member.

23. A measuring device comprising:
a body portion configured to irradiate an object with light and configured to receive reflected light; and
a pair of vehicle body attachment members configured to attach the body portion to a vehicle body while independently holding both sides in a width direction of the body portion.

24. The measuring device according to claim 23,
wherein the body portion includes:
a sensor unit including a light emitting element configured to emit light, and a light receiving element configured to receive the reflected light;
an optical unit configured to irradiate an object with the light emitted from the light emitting element and configured to cause the light receiving element to receive the reflected light;
a holder configured to hold the sensor unit and the optical unit in a relatively movable manner; and
a housing configured to accommodate the sensor unit and the optical unit;
the holder includes a projection portion protruding from a gap of the housing to outside of the housing, and
the vehicle body attachment member holds the projection portion.

25. The measuring device according to claim 24,
wherein the vehicle body attachment member sandwiches the projection portion via a damper member.

26. The measuring device according to claim 25,
wherein, between the vehicle body attachment member and the damper member, a gap is provided in a direction perpendicular to a direction in which the vehicle body attachment member sandwiches the projection portion.

27. The measuring device according to claim 26,
wherein the vehicle body attachment member includes a contact portion configured to come into contact with the projection portion.

28. A method for manufacturing a measuring device, the method comprising:
a step of preparing a body portion configured to irradiate an object with light and receive reflected light, and a pair of vehicle body attachment members configured to attach the body portion to a vehicle body;
a step of adjusting a positional relation between the pair of vehicle body attachment members; and
a step of holding both respective sides in a width direction of the body portion by the pair of vehicle body attachment members, in a state where the positional relation between the pair of vehicle body attachment members is adjusted.

29. The method for manufacturing a measuring device according to claim 28,
wherein the positional relation between the pair of vehicle body attachment members is adjusted using a jig.

30. The method for manufacturing a measuring device according to claim 29,
wherein each of the vehicle body attachment members includes an attachment hole used for attachment to the vehicle body,
the jig includes a positioning pin, and
the positional relation between the pair of vehicle body attachment members is adjusted by inserting the positioning pin into the attachment hole.

31. The method for manufacturing a measuring device according to claim 29 or 30,
wherein the jig includes a contact portion configured to come into contact with the body portion, and
the body portion is aligned with the vehicle body attachment member by bringing the body portion into contact with the contact portion of the jig.
